# EUROPEAN PATENT APPLICATION

(11) **EP 4 266 851 A1**
(43) Date of publication of application: **25.10.2023**
(21) Application number: 23163467.6
(22) Date of filing: 22.03.2023
(51) Int. Cl.: H10B 51/50, H10B 51/10, H10B 51/20, H01L 29/51, H01L 29/78, H01L 21/28, H01L 29/786

(54) **SEMICONDUCTOR DEVICES AND DATA STORAGE SYSTEMS INCLUDING THE SAME**

(30) Priority: 19.04.2022 KR 20220048391
(71) Applicant: Samsung Electronics Co., Ltd., Suwon-si, Gyeonggi-do 16677 (KR)
(72) Inventor: PARK, Hyunmog, 16677 Suwon-si (KR); LEE, Bongyong, 16677 Suwon-si (KR)
(74) Representative: Marks & Clerk LLP

(57) **Abstract**

A semiconductor device (100) includes gate electrodes (130) extending in a first direction (X), first (VS1_1) and second (VS1_2) vertical structures passing through the gate electrodes, a first upper interconnection, and a second upper interconnection structure, the first and second vertical structures including a back gate electrode (150), a ferroelectric material layer (143), a channel layer (142), and a gate insulating layer (141), the first upper interconnection structure including bit lines (BL1, BL2) extending in a second direction (Y), a first contact plug (173a) connected to a lower surface of a first back gate electrode of the first vertical structure, and a first back gate interconnection (BG1) extending between the bit lines in the second direction and connected to the first contact plug, and the second upper interconnection structure including a second contact plug (173d) connected to an upper surface of a second back gate electrode of the second vertical structure, and a second back gate interconnection (BG4) extending in the second direction and connected to the second contact plug.

## Description

### BACKGROUND

The present inventive concepts relate to a semiconductor device and a data storage system including the same.

In a data storage system requiring data storage, a semiconductor device for storing high-capacity data may be utilized. Accordingly, methods for increasing data storage capacity of semiconductor devices are being researched. For example, as a method for increasing data storage capacity of a semiconductor device, a semiconductor device including memory cells arranged three-dimensionally, instead of memory cells arranged two-dimensionally, has been proposed.

### SUMMARY

Some example embodiments of the present inventive concepts provide a semiconductor device having improved electrical characteristics and reliability.

Some example embodiments of the present inventive concepts provide a data storage system including a semiconductor device having improved electrical characteristics and reliability.

According to some example embodiments of the present inventive concepts, a semiconductor device includes a first structure including a substrate, circuit elements on the substrate, a lower interconnection structure electrically connected to the circuit elements, and lower bonding pads electrically connected to the lower interconnection structure, and a second structure on the first structure, the second structure including a source structure, gate electrodes stacked below the source structure and extending in a first direction, first and second vertical structures passing through the gate electrodes, a first upper interconnection structure below the gate electrodes and the first and second vertical structures, a second upper interconnection structure on the source structure, and upper bonding pads electrically connected to the first and second upper interconnection structures and bonded to the lower bonding pads, wherein each of the first and second vertical structures includes a back gate electrode, a ferroelectric material layer on a side surface of the back gate electrode, a channel layer on a side surface of the ferroelectric material layer and electrically connected to the source structure, and a gate insulating layer between the channel layer and the gate electrodes, wherein the first upper interconnection structure includes bit lines extending in a second direction, intersecting the first direction, a first contact plug electrically connected to a lower surface of a first back gate electrode of the first vertical structure, and a first back gate interconnection extending between the bit lines in the second direction and electrically connected to the first contact plug, and wherein the second upper interconnection structure includes a second contact plug electrically connected to an upper surface of a second back gate electrode of the second vertical structure, and a second back gate interconnection extending in the second direction and electrically connected to the second contact plug.

According to some example embodiments of the present inventive concepts, a semiconductor device includes circuit elements on a substrate; a lower interconnection structure electrically connected to the circuit elements; lower bonding pads electrically connected to the lower interconnection structure; upper bonding pads bonded to the lower bonding pads; a first upper interconnection structure and a second upper interconnection structure electrically connected to the upper bonding pads; gate electrodes between the first upper interconnection structure and the second upper interconnection structure, the gate electrodes stacked spaced apart from each other and extending in a first direction; vertical structures passing through the gate electrodes; and a source structure contacting upper ends of the vertical structures, wherein each of the vertical structures includes a back gate electrode, a ferroelectric material layer on a side surface of the back gate electrode, a channel layer on a side surface of the ferroelectric material layer and electrically connected to the source structure, and a gate insulating layer between the channel layer and the gate electrodes, wherein the vertical structures include first to fourth vertical structures arranged in a line in a second direction, intersecting the first direction, wherein the first upper interconnection structure includes first and second bit lines extending in the second direction and parallel to each other, and first and second back gate interconnections extending in the second direction and parallel to each other between the first and second bit lines, and wherein the second upper interconnection structure includes third and fourth back gate interconnections extending in the second direction on a higher level than the source structure and parallel to each other.

According to some example embodiments of the present inventive concepts, a data storage system includes a semiconductor storage device including a first structure including a substrate and circuit elements on the substrate, a second structure including gate electrodes extending in a first direction and vertical structures passing through the gate electrodes, and an input/output pad electrically connected to the circuit elements; and a controller electrically connected to the semiconductor storage device through the input/output pad and configured to control the semiconductor storage device, wherein the first structure further includes a lower interconnection structure electrically connected to the circuit elements, and lower bonding pads electrically connected to the lower interconnection structure, wherein the second structure further includes upper bonding pads electrically connected to the lower bonding pads, a first upper interconnection structure and a second upper interconnection structure electrically connected to the upper bonding pads, vertical structures passing through the gate electrodes, and a source structure contacting upper ends of the vertical structures, wherein the first upper interconnection structure includes bit lines extending in a second direction intersecting the first direction, a first contact plug electrically connected to a lower surface of a first back gate electrode of the first vertical structure, and a first back gate interconnection extending between the bit lines in the second direction and electrically connected to the first contact plug, and wherein the second upper interconnection structure includes a second contact plug electrically connected to an upper surface of a second back gate electrode of the second vertical structure, and a second back gate interconnection extending in the second direction and electrically connected to the second contact plug.

At least some of the above and other features of the invention are set out in the claims.

### BRIEF DESCRIPTION OF DRAWINGS

The above and other aspects, features, and advantages of the present inventive concepts will be more clearly understood from the following detailed description, taken in conjunction with the accompanying drawings, in which:
FIG. 1 is a simplified circuit diagram illustrating a memory cell array of a semiconductor device according to some example embodiments.
FIGS. 2A and 2B are schematic plan views of a semiconductor device according to some example embodiments.
FIGS. 3A and 3B are schematic cross-sectional views of semiconductor devices according to some example embodiments.
FIG. 4 is a partially enlarged view of a semiconductor device according to some example embodiments.
FIG. 5A is a schematic plan view of a semiconductor device according to some example embodiments, and FIG. 5B is a partially enlarged view of a semiconductor device according to some example embodiments.
FIGS. 6A and 6B are partially enlarged views of a semiconductor device according to some example embodiments.
FIG. 7 is a simplified circuit diagram illustrating a memory cell array of a semiconductor device according to some example embodiments.
FIGS. 8A to 10 are partially enlarged views of semiconductor devices according to some example embodiments.
FIGS. 11A to 15B are schematic cross-sectional views illustrating a method of manufacturing a semiconductor device according to some example embodiments.
FIG. 16 is a view schematically illustrating a data storage system including a semiconductor device according to some example embodiments.
FIG. 17 is a schematic perspective view of a data storage system including a semiconductor device according to some example embodiments.
FIG. 18 is a cross-sectional view schematically illustrating a semiconductor package according to some example embodiments.

### DETAILED DESCRIPTION

Hereinafter, some example embodiments of the present inventive concepts will be described with reference to the accompanying drawings. Hereinafter, it can be understood that terms such as "upper," "upper portion," "upper surface," "on," "lower," "lower portion," "lower surface," "below," "side surface," or the like is referred based on the drawings, except for being denoted by reference numerals and referred to separately.

When an element is referred to as being "connected to" or "electrically connected to" another element, the element may be directly connected to the other element, or one or more other intervening elements may be present. For example, an element described as being "connected to" another element may be "electrically connected to" the other element. In contrast, when an element is referred to as being "directly connected to" another element there are no intervening elements present.

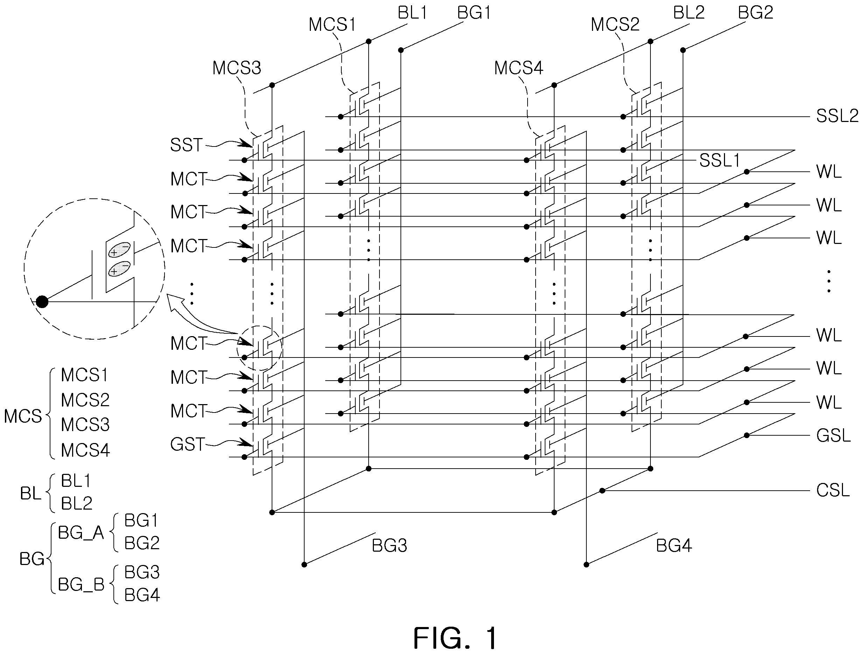

FIG. 1 is a simplified circuit diagram illustrating a memory cell array of a semiconductor device according to some example embodiments.

Referring to FIG. 1, a memory cell array of a semiconductor device may include memory cell strings MCS, word lines WL, back gate lines BG, a ground select line GSL, a string select line (e.g., SSL1 and/or SSL2), and/or a common source line CSL. A plurality of memory cell strings MCS may be connected to bit lines BL in parallel. The plurality of memory cell strings MCS may be commonly connected to the common source line CSL. For example, a plurality of memory cell strings (e.g., MCS1, MCS2, MCS3, and/or MCS4) may be disposed between a plurality of bit lines (e.g., BL1 and/or BL2) and one common source line CSL. For example, first and/or third memory cell strings MCS1 and MCS3 may be connected to a first bit line BL1, and second and/or fourth memory cell strings MCS2 and MCS4 may be connected to a second bit line BL2. A ground select transistor GST and a string select transistor SST may be connected to memory cells MCT in series.

Memory cells MCT connected in series may be controlled by the word lines WL and/or the back gate lines BG. Each, or one or more, of the memory cells MCT may include a data storage element. For example, as illustrated in the enlarged view, each, or one or more, of the memory cells MCT may include a channel and/or a ferroelectric, between the word line WL and the back gate line BG. The ferroelectric may form an electric dipole by ferroelectric polarization, which may be spontaneous polarization.

Gate layers of the memory cells MCT disposed at substantially the same distance from the common source line CSL may be connected in common to one of the word lines WL to be in an equipotential state. Alternatively, even when the gate layers of the memory cells MCT are disposed at substantially the same distance from the common source lines CSL, the gate layers disposed in different rows or columns may be independently controlled.

The ground select transistor GST may be controlled by the ground select line GSL, and/or may be connected to the common source line CSL. The string select transistors SST may be respectively controlled by the string select lines (e.g., SSL1 and/or SSL2), and/or may be connected to the bit lines (e.g., BL1 and/or BL2). FIG. 1 illustrates a structure in which one ground select transistor GST and two string select transistors SST are respectively connected to a plurality of memory cells MCT connected in series, but is not limited thereto. Highest and lowest word lines among the word lines WL may be dummy lines.

When a signal is applied to the string select transistors SST through the string select lines (e.g., SSL1 and/or SSL2), the signals applied through the bit lines e.g., BL1 and/or BL2) may be transmitted to the memory cells MCT connected to each other in series, to perform operations of reading and writing data. Also, an erase operation for erasing data written in the memory cells MCT may be performed by applying a predetermined (or alternately given) erase voltage through the back gate interconnection BG.

The back gate lines BG may be disposed on each, or one or more, of the memory cell strings MCS to apply an electric field to each, or one or more, of the memory cells MCT. When the memory cell array includes the back gate lines BG, compared to a case in which the back gate lines BG is absent, a disturbance defect in the ferroelectric may be reduced or prevented or minimized during an operation of the memory cells MCT, to improve electrical characteristics of the semiconductor device.

The back gate lines BG may include a first back gate line group BG_A parallel to the bit lines (e.g., BL1 and/or BL2), and/or a second back gate line group BG_B located opposite to the bit lines (e.g., BL1 and/or BL2) and/or the memory cell strings MCS. The first back gate line group BG_A may include first and/or second back gate lines (e.g. interconnections) BG1 and BG2 for applying electrical signals to the first and/or second memory cell strings MCS1 and MCS2, respectively, and/or the second back gate line group BG_B may include third and/or fourth back gate lines BG3 and BG4 for applying electrical signals to the third and/or fourth memory cell strings MCS3 and MCS4, respectively. In the memory cell array, the back gate lines BG may be disposed in an upper region and/or a lower region of the memory cell strings MCS, respectively, to efficiently use a space in which interconnections are disposed. Therefore, a degree of integration of the semiconductor device may be improved.

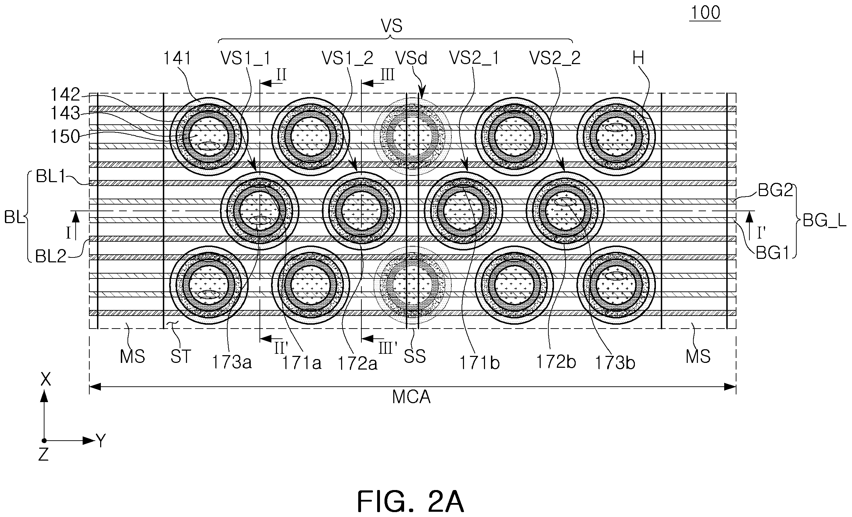

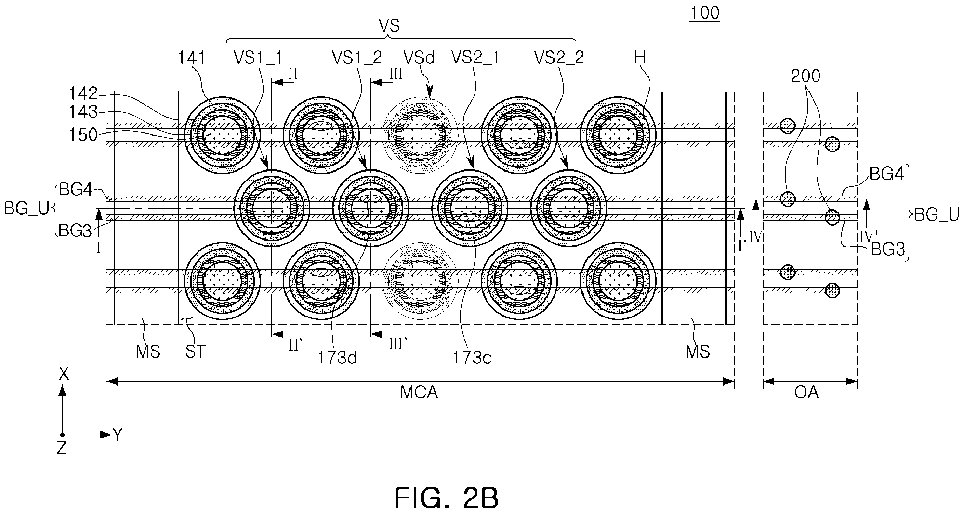

FIGS. 2A and 2B are schematic plan views of a semiconductor device according to some example embodiments.

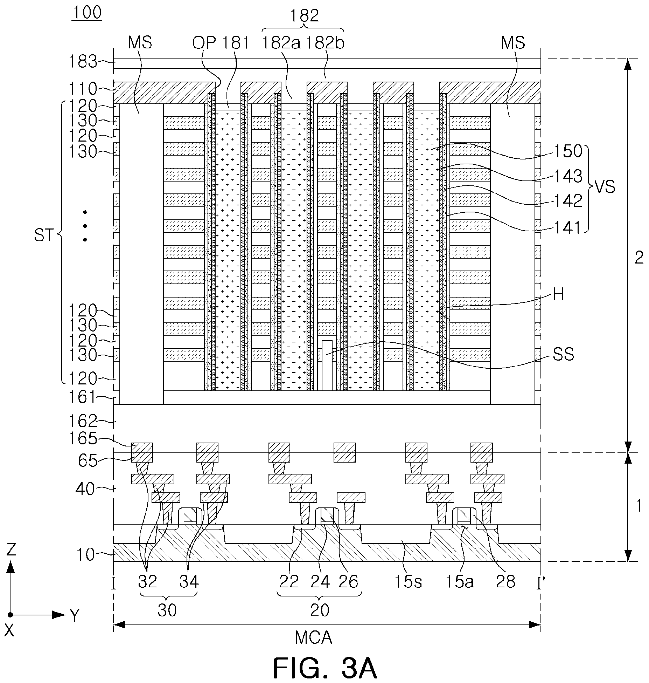

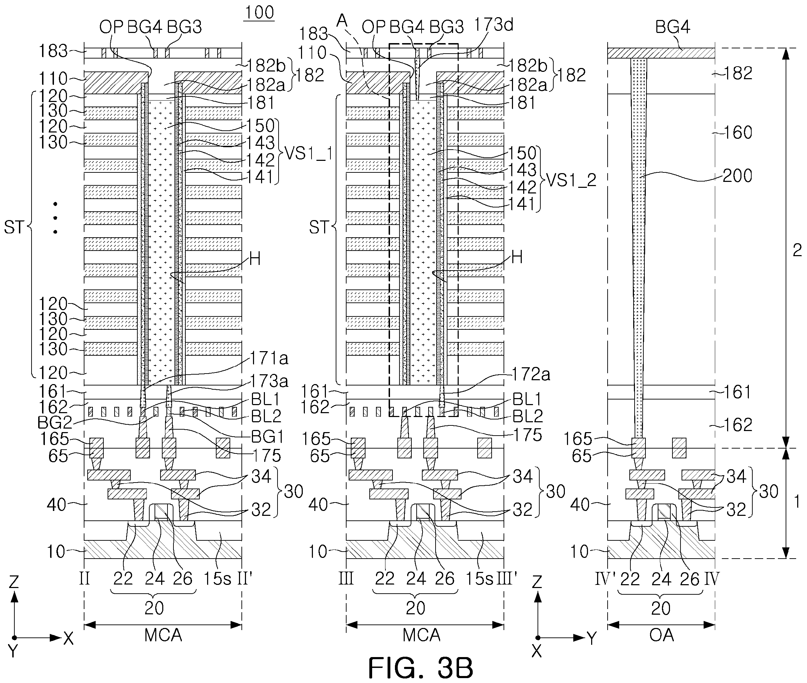

FIGS. 3A and 3B are schematic cross-sectional views of semiconductor devices according to some example embodiments. FIG. 3A illustrates a cross-sectional view of the semiconductor device of FIGS. 2A and 2B, taken along line I-I', and FIG. 3B illustrates cross-sectional views of the semiconductor device of FIGS. 2A and 2B, taken along lines II-II', III-III', and IV-IV'.

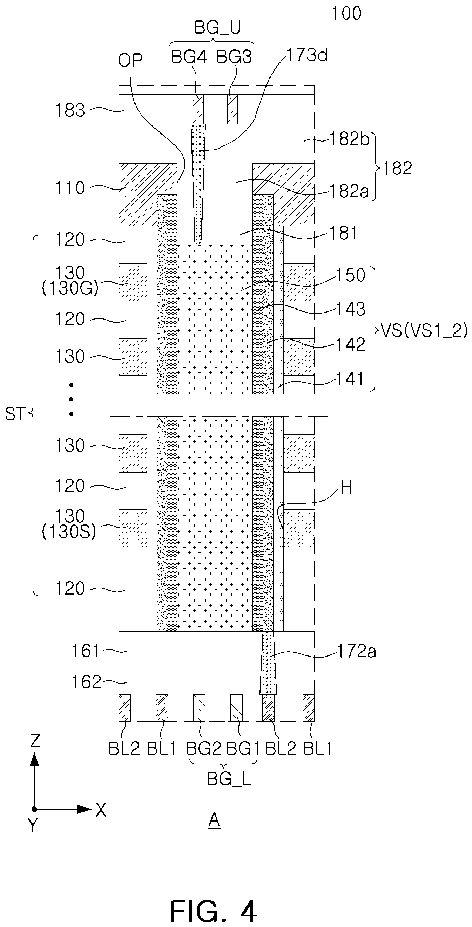

FIG. 4 is a partially enlarged view of a semiconductor device according to some example embodiments. FIG. 4 illustrates an enlarged view of portion 'A' of FIG. 3B.

Referring to FIGS. 2A to 4, a semiconductor device 100 may include a first structure 1 including a substrate 10, and/or a second structure 2. The second structure 2 may be disposed on the first structure 1. The first structure 1 may be a region in which a peripheral circuit region of the semiconductor device 100 is disposed, and the peripheral circuit region may include a row decoder, a page buffer, and/or other peripheral circuits. The second structure 2 may be a region in which memory cells of the semiconductor device 100 are disposed, and may include vertical structures VS including gate electrodes 130 and/or a channel layer 142.

The first structure 1 may include a substrate 10, device isolation layers 15s on the substrate 10 and defining an active region 15a, circuit elements 20 disposed on the substrate 10, a lower interconnection structure 30 electrically connected to the devices 20, a lower insulating layer 40, and/or a lower bonding pad 65.

The substrate 10 may include a semiconductor material, for example, a group IV semiconductor, a group III-V compound semiconductor, and/or a group II-VI compound semiconductor. The substrate 10 may be provided as a bulk wafer or as an epitaxial layer. The device isolation layers 15s may be disposed in the substrate 10, and source/drain regions 22 including impurities may be disposed in a portion of the active region 15a.

The circuit elements 20 may include a transistor including a source/drain region 22, a circuit gate dielectric layer 24, and/or a circuit gate electrode 26, respectively. Source/drain regions 22 may be disposed on both sides of the circuit gate electrode 26 in the active region 15a. The circuit gate dielectric layer 24 may be disposed between the active region 15a and the circuit gate electrode 26. Spacer layers 28 may be disposed on both sides of the circuit gate electrode 26.

The lower interconnection structure 30 may be electrically connected to the circuit elements 20. The lower interconnection structure 30 may include a lower contact 32 and/or a lower interconnection 34. A portion of the lower contacts 32 may be connected to the source/drain regions 22. The lower contact 32 may electrically connect the lower interconnection structures 34 disposed on different levels to each other. The lower interconnection structure 30 may include a conductive material, for example, a metal material such as tungsten (W), titanium (Ti), tantalum (Ta), copper (Cu), aluminum (Al), cobalt (Co), molybdenum (Mo), ruthenium (Ru), and/or the like. A barrier layer formed of a material such as tungsten nitride (WN), titanium (Ti), and/or titanium nitride (TiN) may be disposed on bottom and side surfaces of the lower interconnection structure 30. The number of layers and an arrangement of the lower contacts 32 and/or the lower interconnection 34 constituting the lower interconnection structure 30 may be variously changed.

The lower insulating layer 40 may be disposed to cover the substrate 10, the circuit elements 20, and/or the lower interconnection structure 30. The lower insulating layer 40 may be formed of an insulating material such as silicon oxide and/or silicon nitride. The lower insulating layer 40 may include a plurality of insulating layers. The lower insulating layer 40 may include an etch stop layer formed of silicon nitride.

The lower bonding pad 65 may be electrically connected to the lower interconnection structure 30. The lower bonding pad 65 may include a conductive material, for example, tungsten (W), copper (Cu), aluminum (Al), and/or the like, and a diffusion barrier may be further included, respectively. Although not illustrated, the first structure 1 may further include a lower bonding insulating layer covering a side surface of the lower bonding pad 65, wherein the lower bonding insulating layer may include at least one of SiCN, SiO, SiN, SiOC, SiON, and/or SiOCN.

The lower bonding pad 65 may be bonded or connected by direct contact with an upper bonding pad 165 by hybrid bonding. For example, the lower bonding pad 65 may be in contact with the upper bonding pad 165 and may be bonded by copper-to-copper bonding. A lower bonding insulating layer 40 (sometimes referred to as a lower insulating layer) and/or an upper bonding insulating layer 162 (sometimes referred to as a lower capping insulation layer), disposed in the vicinity of the bonding surface of the first structure 1 and/or the second structure 2, may be in contact with each other, and may be bonded by dielectric-to-dielectric bonding. The lower bonding pad 65 may provide an electrical connection path between the first structure 1 and the second structure 2, together with the upper bonding pad 165.

The second structure 2 may include a source structure 110 on the first structure 1, a stack structure ST including interlayer insulating layers 120 and gate electrodes 130, spaced apart from each other and stacked below the source structure 110, separation patterns MS passing through the stack structure ST and extending in an X-direction, vertical structures VS passing through the stack structure ST between the separation patterns MS, a first upper interconnection structure below the stack structure ST, a second upper interconnection structure on the source structure 110, and/or an upper bonding structure including an upper bonding pad 165 electrically connected to the first and/or second upper interconnection structures.

The first upper interconnection structure may include bit lines BL, lower back gate interconnections BG_L, and/or lower contact plugs 171a, 171b, 172a, 172b, 173a, and 173b. The second upper interconnection structure may include upper back gate interconnections BG_U and/or upper contact plugs 173c and/or 173d.

To individually control back gate electrodes 150 of a plurality of vertical structures VS, forming back gate interconnections BG only between the bit lines BL of the first upper interconnection structure may cause an increase in difficulty of a semiconductor manufacturing process and causes an increase in size of the semiconductor chip due to limits of pitches of interconnection structures. According to some example embodiment of the present inventive concepts, the back gate interconnections BG for individually controlling the back gate electrodes 150 in the vertical structures VS may be disposed above/below the back gate electrodes 150. Ferroelectric disturbance defects of the memory cells by the back gate electrode 150 may be reduced or prevented or minimized and a space in which the back gate interconnections BG are disposed may be efficiently used, to improve electrical characteristics and a degree of integration of the semiconductor device.

Each, or one or more, of the vertical structures VS may include a gate insulating layer 141, a channel layer 142, a ferroelectric material layer 143, and/or a back gate electrode 150, sequentially disposed from an inner wall of a vertical hole H. In the semiconductor device 100, one memory cell string may be configured with the channel layer 142 as a central portion, and a plurality of memory cell strings may be arranged in columns and rows in X and Y-directions.

The second structure 2 may further include lower capping insulating layers 161 and/or 162, upper capping insulating layers 181, 182, and/or 183, a contact plug 175, and/or a through-contact plug 200.

The source structure 110 may be disposed on the stack structure ST. The source structure 110 may be in contact with the vertical structures VS to provide a common source region. The source structure 110 may include a semiconductor material, such as a group IV semiconductor, a group III-V compound semiconductor, and/or a group II-VI compound semiconductor. For example, the group IV semiconductor may include silicon (Si), germanium (Ge), and/or silicon-germanium (SiGe). The source structure 110 may include a conductive material, and may include impurities and/or doped regions including impurities. The impurities may include at least one of boron (B), aluminum (Al), gallium (Ga), and/or indium (In) as a P-type dopant, and/or may include at least one of phosphorus (P), arsenic (As), and/or antimony (Sb) as an N-type dopant. For example, at least a portion of the source structure 110 may be formed of polycrystalline silicon having an N-type conductivity. In another example, the source structure 110 may be formed of at least one of a metal such as tungsten (W), titanium (Ti), tantalum (Ta), copper (Cu), aluminum (Al), molybdenum (Mo), ruthenium (Ru), and/or the like, or a metal-semiconductor compound such as tungsten silicide (WSi), and/or titanium silicide (TiSi)v.

The source structure 110 may include openings OP passing through the source structure 110, in a position vertically overlapping the vertical structures VS in the Z-direction. A width of each, or one or more, of the openings OP may be narrower than a width of each, or one or more, of the vertical structures VS. A first portion 182a of a second upper capping insulating layer 182 may be disposed in the opening OP of the source structure 110. The first portion 182a of the second upper capping insulating layer 182 may be a portion extending into the opening OP from a second portion 182b of the second upper capping insulating layer 182 covering an upper surface of the source structure 110.

The gate electrodes 130 may be stacked below the source structure 110 to be spaced apart from each other in the Z-direction, and may form a portion of the stack structure ST in a memory cell array region MCA. The gate electrodes 130 may extend in the X-direction. The gate electrodes 130 between a pair of separation patterns MS may form one memory block. The gate electrodes 130 may be disposed between the first upper interconnection structure and/or the source structure 110.

The gate electrodes 130 may include a ground select gate electrode 130G forming a gate of a ground select transistor, a string select gate electrode 130S forming a gate of a string select transistor, and/or memory gate electrodes 130 forming gates of a plurality of memory cells. Storage capacity of the semiconductor device 100 may be determined according to the number of memory gate electrodes 130 forming gates of a plurality of memory cells. One or a plurality of ground select gate electrodes 130G and/or string select gate electrodes 130S may be disposed, respectively.

The gate electrodes 130 may extend in the X-direction to form a stepped structure in some regions. Due to the stepped structure, the gate electrode 130 may have a pad region exposed from the interlayer insulating layers 120 by extending an upper gate electrode longer than a lower gate electrode, disposed below the upper gate electrode. Gate contact plugs may be connected to the pad regions.

The gate electrodes 130 may include a metal material, for example, tungsten (W). In some example embodiments, the gate electrodes 130 may include polycrystalline silicon and/or a metal-semiconductor compound (e.g., titanium silicide (TiSi), cobalt silicide (CoSi), nickel silicide (NiSi), tungsten silicide (WSi), or the like). The gate electrodes 130 may include a first layer and/or a second layer, respectively, and the first layer may cover upper and/or lower surfaces of the second layer, and may be extended between the vertical structures VS and/or the second layer. The first layer may include a high-κ material such as aluminum oxide (AlO) or the like, and the second layer may include at least one of titanium (Ti), titanium nitride (TiN), tantalum (Ta), tantalum nitride (TaN), tungsten (W), and/or tungsten nitride (WN).

The gate electrodes 130 may form a gate stacking group, and in some example embodiments of the present inventive concepts, the gate stacking group may have a double stack structure including a lower gate stacking group and an upper gate stacking group, and may also have a multi-stack structure.

The interlayer insulating layers 120 may be disposed between the gate electrodes 130. Like the gate electrodes 130, the interlayer insulating layers 120 may be spaced apart from each other in the Z-direction, perpendicular to a lower surface of the source structure 110, and may be disposed to extend in the X-direction. The interlayer insulating layers 120 may include an insulating material such as silicon oxide and/or silicon nitride.

The separation patterns MS may be disposed to pass through the gate electrodes 130 and extend in the X-direction. The separation patterns MS may be disposed to pass through the stack structure ST and contact the source structure 110. The separation patterns MS may have a shape in which a width thereof decreases toward the source structure 110 due to a high aspect ratio. The separation patterns MS may be formed of an insulating material such as silicon oxide and/or silicon nitride.

As illustrated in FIGS. 2A and 2B, the vertical structures VS may form one memory cell string in the memory cell array region MCA, respectively, and may be disposed to be spaced apart from each other while forming rows and columns. The vertical structures VS may be disposed to form a grid pattern between the separation patterns MS or may be disposed in a zigzag shape in one direction. The vertical structures VS may be disposed in vertical holes H passing through the stack structure ST in the Z-direction. The vertical structures VS may have a columnar shape, and may have inclined side surfaces narrowing toward the source structure 110 according to an embodiment.

Each, or one or more, of the vertical structures VS may include a back gate electrode 150, and/or a gate insulating layer 141, a channel layer 142, and/or a ferroelectric material layer 143, annularly surrounding the back gate electrode 150. The back gate electrode 150 may be spaced apart from the channel layer 142, may be disposed in a central region of the vertical hole H, and may extend in the Z-direction. The ferroelectric material layer 143 may be disposed on a side surface of the back gate electrode 150, the channel layer 142 may be disposed on a side surface of the ferroelectric material layer 143 and may be electrically connected to the source structure 110, and the gate insulating layer 141 may be disposed between the gate electrodes 130 and the channel layer 142.

The gate insulating layer 141 may extend along an inner wall of the vertical hole H to contact the source structure 110. An upper surface of the gate insulating layer 141 may be substantially coplanar with an upper surface of an uppermost interlayer insulating layer 120. The gate insulating layer 141 may include silicon oxide and/or silicon nitride.

The channel layer 142 may be annularly disposed in the vertical hole H, and may be disposed between the gate insulating layer 141 and the ferroelectric material layer 143. An upper surface of the channel layer 142 and/or an upper portion of an outer side surface of the channel layer 142 may be in direct contact with the source structure 110. Therefore, the channel layer 142 may be electrically connected to the source structure 110. The channel layer 142 may extend longer than the gate insulating layer 141 in the Z-direction.

For example, the channel layer 142 may include a semiconductor material such as polycrystalline silicon and/or monocrystalline silicon.

For example, the channel layer 142 may include an oxide semiconductor material. For example, the channel layer 142 may include an oxide including at least one of indium (In), zinc (Zn), and/or gallium (Ga). For example, the channel layer 142 may include at least one of zinc tin oxide (ZTO), indium zinc oxide (IZO), ZnO, indium gallium zinc oxide (IGZO), indium gallium silicon oxide (IGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HflnZnO), tin indium zinc oxide (SnInZnO), aluminum tin indium zinc oxide (AlSnInZnO), silicon indium zinc oxide (SiInZnO), zinc tin oxide (ZnSnO), aluminum zinc tin oxide (AlZnSnO), gallium zinc tin oxide (GaZnSnO), zirconium zinc tin oxide (ZrZnSnO), and/or indium gallium silicon oxide (InGaSiO).

The oxide semiconductor material of the channel layer 142 may have an amorphous or crystalline structure. The oxide semiconductor material of the channel layer 142 may have N-type conductivity, but the present inventive concepts are not limited thereto.

For example, the channel layer 142 may include a two-dimensional material (2D material) layer in which atoms form a predetermined (or alternately given) crystal structure and form a channel of a transistor. The two-dimensional material layer may include at least one of a transition metal dichalcogenide material layer (TMD), a black phosphorous material layer, or a hexagonal boron-nitride material layer (hBN). For example, the two-dimensional material layer may include at least one of BiOSe, Crl, WSe₂, MoS₂, TaS, WS, SnSe, ReS, β-SnTe, MnO, AsS, P(black), InSe, h-BN, GaSe, GaN, SrTiO, MXene, and/or Janus 2D materials, which are capable of forming a two-dimensional material.

The ferroelectric material layer 143 may be disposed in an annular shape to surround the outer side surface of the back gate electrode 150. The ferroelectric material layer 143 may be disposed between the channel layer 142 and the back gate electrode 150. The ferroelectric material layer 143 may extend longer than the gate insulating layer 141 in the Z-direction, but the present inventive concepts are not limited thereto.

The ferroelectric material layer 143 may include at least one of, for example, hafnium (Hf), zirconium (Zr), silicon (Si), yttrium (Y), aluminum (Al), gadolinium (Gd), strontium (Sr), lanthanum (La), titanium (Ti), and/or oxides thereof. For example, the ferroelectric material layer 143 may include at least one of hafnium oxide (HfO₂), zirconium oxide (ZrO₂), and/or hafnium zirconium oxide (HZO), but the present inventive concepts are not limited thereto. The ferroelectric material layer 143 may have a relatively large dielectric constant, and may form an electric dipole by ferroelectric polarization, which may be spontaneous polarization. The ferroelectric material layer 143 may have residual polarization due to a dipole even in the absence of an external electric field.

The back gate electrode 150 may be disposed in the vertical hole H to fill an inner space of the ferroelectric material layer 143. The back gate electrode 150 may have an upper surface recessed onto a level, lower than an upper end of the channel layer 142. The upper surface of the back gate electrode 150 may be located on a level, lower than a lower surface of the source structure 110.

The back gate electrode 150 may include a metal material, for example, tungsten (W). The back gate electrode 150 may include, for example, at least one of titanium (Ti), titanium nitride (TiN), tantalum (Ta), tantalum nitride (TaN), tungsten (W), and/or tungsten nitride (WN). In some example embodiments, the back gate electrode 150 may include polycrystalline silicon and/or a metal-semiconductor compound (e.g., titanium silicide (TiSi), cobalt silicide (CoSi), nickel silicide (NiSi), tungsten silicide (WSi), or the like).

The vertical structures VS may include first to fourth vertical structures VS1_1, VS1_2, VS2_1, and VS2_2, arranged in a line in the Y-direction. The vertical structures VS may further include a dummy vertical structure VSd overlapping a string separation pattern SS. The dummy vertical structure VSd may have the same structure as the first to fourth vertical structures VS1_1, VS1_2, VS2_1, and VS2_2, but may not perform a substantial function when the semiconductor device 100 is operated. The dummy vertical structure VSd may not be electrically connected to the bit lines BL and/or the back gate interconnections BG.

A channel layer 142 of the first vertical structure VS 1_1 may be electrically connected to the first bit line BL1, and a back gate electrode 150 of the first vertical structure VS1_1 may be electrically connected to the first back gate interconnection BG1. The first vertical structure VS1_1 may correspond to the first memory cell string MCS1 of FIG. 1.

A channel layer 142 of the second vertical structure VS1_2 may be electrically connected to the second bit line BL2, and a back gate electrode 150 of the second vertical structure VS1_2 may be electrically connected to the fourth back gate interconnection BG4. The second vertical structure VS1_2 may correspond to the fourth memory cell string MCS4 of FIG. 1.

A channel layer 142 of the third vertical structure VS2_1 may be electrically connected to the first bit line BL1, and a back gate electrode 150 of the third vertical structure VS2_1 may be electrically connected to the third back gate interconnection BG3. The third vertical structure VS2_1 may correspond to the third memory cell string MCS3 of FIG. 1.

A channel layer 142 of the fourth vertical structure VS2_2 may be electrically connected to the second bit line BL2, and a back gate electrode 150 of the fourth vertical structure VS2_2 may be electrically connected to the second back gate interconnection BG2. The fourth vertical structure VS2_2 may correspond to the second memory cell string MCS2 of FIG. 1.

A pair of bit lines (e.g., BL1 and BL2) and/or a pair of lower back gate interconnections (e.g. lines) (e.g., BG1 and BG2) may be disposed below each, or one or more, of the vertical structures VS arranged in a row in the Y-direction, and a pair of upper back gate interconnections (e.g., BG3 and BG4) may be disposed on each, or one or more, of the vertical structures VS arranged in a row in the Y-direction.

The bit lines BL may be disposed between the vertical structures VS and the upper bonding pad 165, and may extend in the Y-direction. The first and/or second bit lines BL1 and BL2 may overlap the vertical structures VS, arranged in a row in the Y-direction, in the Z-direction. The bit lines BL may overlap the channel layer 142 in the Z-direction. The bit lines BL may include a conductive pattern, and/or a barrier layer covering side and/or bottom surfaces of the conductive pattern. The barrier layer may include, for example, at least one of titanium (Ti), titanium nitride (TiN), tantalum (Ta), and/or tantalum nitride (TaN). The conductive pattern may include a metal material, for example, at least one of tungsten (W), titanium (Ti), copper (Cu), cobalt (Co), aluminum (Al), and/or an alloy thereof. The bit lines BL may be connected to contact plugs 175, to be electrically connected to upper bonding pads 165.

The lower back gate interconnections BG_L may be disposed on substantially the same level as the bit lines BL, and may be disposed to be parallel to the bit lines BL. The lower back gate interconnections BG_L may extend in the Y-direction. The lower back gate interconnections BG_L may be disposed between the first and/or second bit lines BL1 and BL2, and may overlap the vertical structures VS, arranged in a row in the Y-direction, in the Z-direction. The lower back gate interconnections BG_L may overlap the back gate electrode 150 in the Z-direction. The lower back gate interconnections BG_L may include a first back gate interconnection BG1 and/or a second back gate interconnection BG2, arranged in parallel with each other. Each, or one or more, of the lower back gate interconnections BG_L may include a conductive pattern, and/or a barrier layer covering side and/or bottom surfaces of the conductive pattern. The lower back gate interconnections BG_L may be connected to the contact plugs 175, to be electrically connected to the upper bonding pads 165.

The lower contact plugs 171a, 171b, 172a, 172b, 173a, and/or 173b may include bit line contact plugs 171a, 171b, 172a, and/or 172b, electrically connecting the channel layers 142 of the vertical structures VS to the bit lines BL, respectively. The bit line contact plugs 171a, 171b, 172a, and/or 172b may include a first bit line contact plugs 171a electrically connecting the channel layer 142 of the first vertical structure VS1_1 and the first bit line BL1 to each other, a second bit line contact plug 172a electrically connecting the channel layer 142 of the second vertical structure VS1_2 and the second bit line BL2 to each other, a third bit line contact plug 171b electrically connecting the channel layer 142 of the third vertical structure VS2_1 and the first bit line BL1 to each other, and/or a fourth bit line contact plug 172b electrically connecting the channel layer 142 of the fourth vertical structure VS2_2 and the second bit line BL2 to each other.

The lower contact plugs 171a, 171b, 172a, 172b, 173a, and 173b may include lower back gate contact plugs 173a and 173b electrically connecting the back gate electrodes 150 of the vertical structures VS to the lower back gate interconnections BG_L, respectively. The lower back gate contact plugs 173a and 173b may include a first lower back gate contact plug 173a electrically connecting the back gate electrode 150 of the first vertical structure VS1_1 and the first back gate interconnection BG1 to each other, and a second lower back gate contact plug 173b electrically connecting the back gate electrode 150 of the fourth vertical structure VS2_2 and the second back gate interconnection BG2 to each other.

Each, or one or more, of the lower contact plugs 171a, 171b, 172a, 172b, 173a, and/or 173b may include a conductive pattern, and/or a barrier layer (not pictured) covering side and/or bottom surfaces of the conductive pattern. In some example embodiments, an arrangement of each, or one or more, of the lower contact plugs 171a, 171b, 172a, 172b, 173a, and/or 173b may be variously changed.

The upper back gate interconnections BG_U may be disposed on the source structure 110, and may be disposed on a level, higher than the upper surface of the source structure 110. The upper back gate interconnections BG_U may extend in the Y-direction. The upper back gate interconnections BG_U may overlap the vertical structures VS, arranged in a line in the Y-direction, in the Z-direction. The upper back gate interconnections BG_U may overlap the back gate electrode 150 in the Z-direction. The upper back gate interconnections BG_U may include a third back gate interconnection BG3 and a fourth back gate interconnection BG4, arranged in parallel with each other. Each, or one or more, of the upper back gate interconnections BG_U may include a conductive pattern, and/or a barrier layer covering side and/or bottom surfaces of the conductive pattern (not pictured).

The upper back gate interconnections BG_U may be electrically connected to the upper bonding pads 165 through the through-contact plugs 200 disposed in a connection region OA on at least one side of the memory cell array region MCA.

The upper contact plugs 173c and/or 173d may pass through the opening OP of the source structure 110 and pass through the first upper capping layer 181 to directly contact the back gate electrodes 150. The upper contact plugs 173c and/or 173d may include a first upper back gate contact plug 173c electrically connecting the back gate electrode 150 of the third vertical structure VS2_1 and the third back gate interconnection BG3 to each other, and a second upper back gate contact plug 173d electrically connecting the back gate electrode 150 of the second vertical structure VS1_2 and the fourth back gate interconnection BG4 to each other.

Each, or one or more, of the upper contact plugs 173c and/or 173d may include a conductive pattern, and/or a barrier layer covering side and bottom surfaces of the conductive pattern (not pictured). In some example embodiments, an arrangement of each, or one or more, of the upper contact plugs 173c and/or 173d may be variously changed.

The lower capping insulating layers 161 and/or 162 may be disposed below the stack structure ST, and the upper capping insulating layers 181, 182, and/or 183 may be disposed on the stack structure ST. A first upper capping insulating layer 181 may be disposed to fill a partial region of the vertical hole H, below the opening OP of the source structure 110. A second upper capping insulating layer 182 may be disposed on the source structure 110, and a third upper capping insulating layer 183 may be disposed on the second upper capping insulating layer 182. The lower capping insulating layers 161 and/or 162 and/or the upper capping insulating layers 181, 182, and/or 183 may include at least one of silicon oxide, silicon nitride, silicon oxynitride, silicon oxycarbide, and/or silicon carbonitride, respectively.

The through-contact plug 200 may pass through the insulating structures (e.g., 160, 161, 162, and/or 182) in the Z-direction in the connection region OA, and may be in direct contact with the upper bonding pad 165. The through-contact plug 200 may be, for example, connected to the fourth back gate interconnection BG4 among the upper back gate interconnections BG_U, and may electrically connect the fourth back gate interconnection BG4 to the circuit elements 20. The through-contact plug 200 may include a conductive pattern, and/or a barrier layer covering side and/or bottom surfaces of the conductive pattern (not pictured).

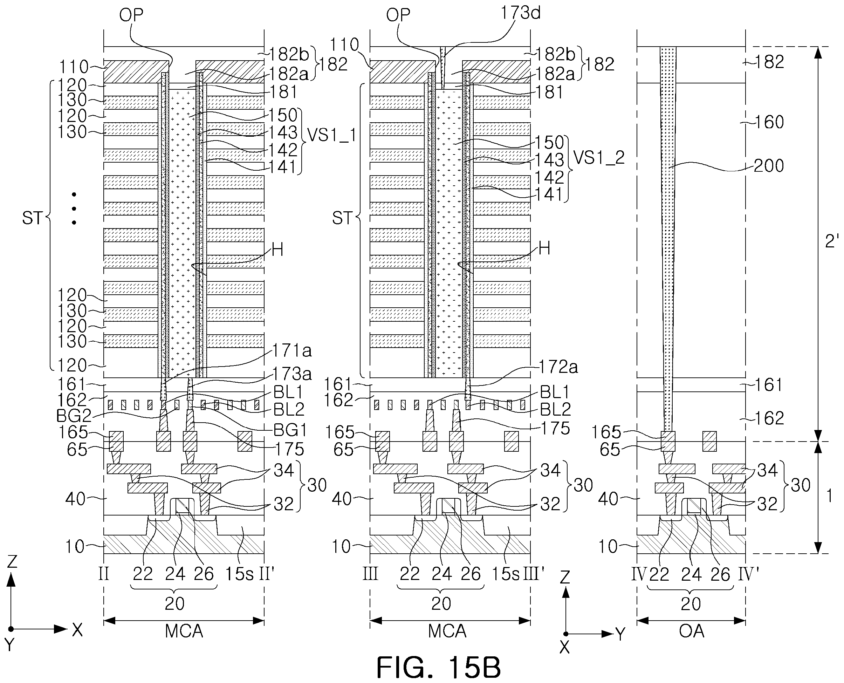

The through-contact plug 200 may be formed after bonding a first structure 1 and a second structure 2', as illustrated in FIG. 15B. The through-contact plug 200 may have an inclined side surface narrowing toward the first structure 1.

In some example embodiments, before bonding a first structure 1 and a second structure 2', a through-contact plug 200 may be previously formed in the second structure 2' in a connection region OA. In this case, the through-contact plug 200 may have an inclined side surface narrowing away from the first structure 1, may be electrically connected to circuit elements 20 of the first structure 1, and/or may be connected through separate interconnection structures and/or contact plugs.

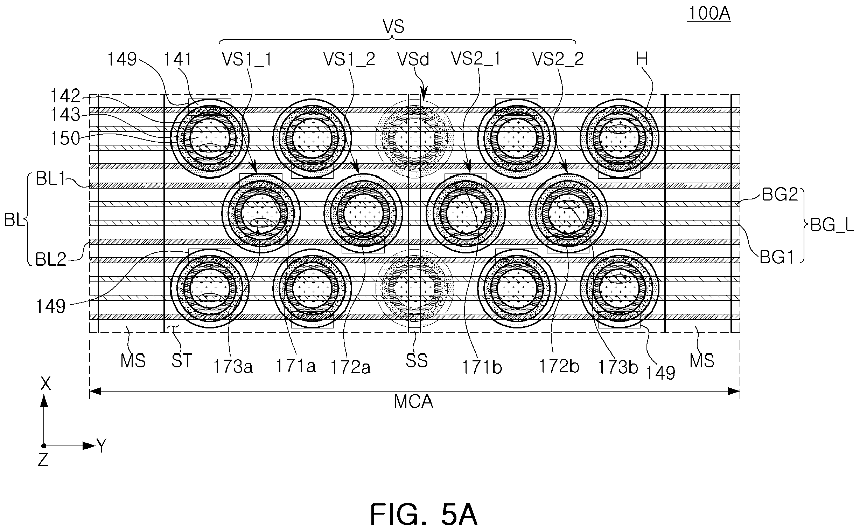

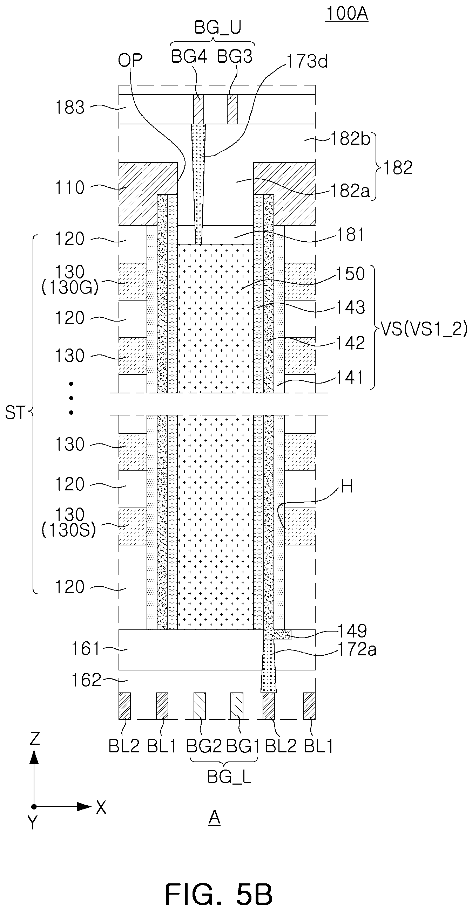

FIG. 5A is a schematic plan view of a semiconductor device according to some example embodiments, and FIG. 5B is a partially enlarged view of a semiconductor device according to some example embodiments. FIG. 5A illustrates a region corresponding to FIG. 2A, and FIG. 5B illustrates a region corresponding to FIG. 4.

Referring to FIGS. 5A and 5B, a semiconductor device 100A may further include channel pads 149. The channel pads 149 may be disposed between a channel layer 142 and bit lines BL. For example, the channel pad 149 may extend from a lower portion of the channel layer 142, and may be bent to cover a lower surface of a gate insulating layer 141. By including the channel pad 149 providing a surface having a larger area than the channel layer 142, bit line contact plugs 171a, 171b, 172a, and/or 172b may be stably connected to the channel layer 142, and a margin of an etching process for forming the bit line contact plugs 171a, 171b, 172a, and/or 172b may be secured. The channel pad 149 may be formed of the same material as the channel layer 142.

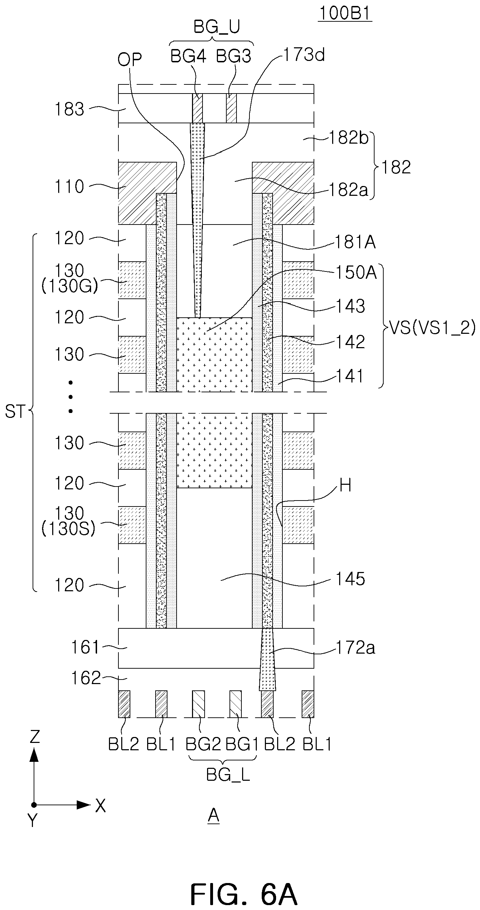

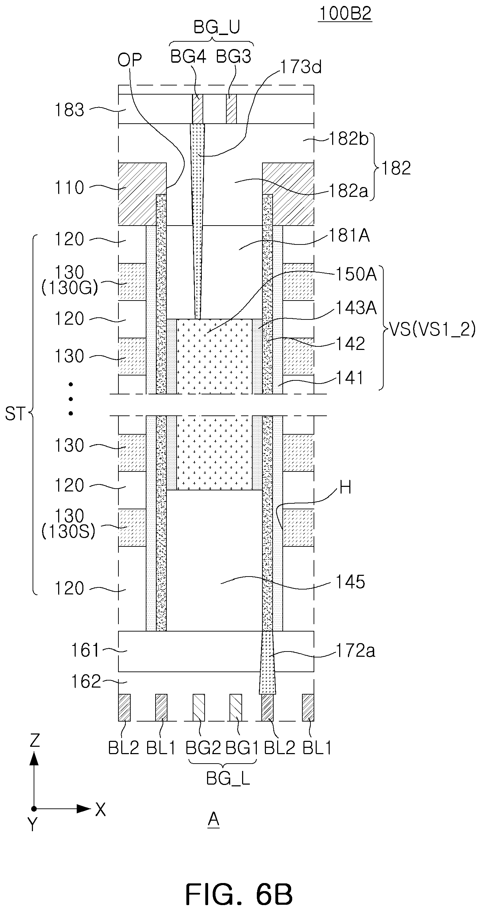

FIGS. 6A and 6B are partially enlarged views of a semiconductor device according to some example embodiments. FIGS. 6A and 6B illustrate regions corresponding to FIG. 4.

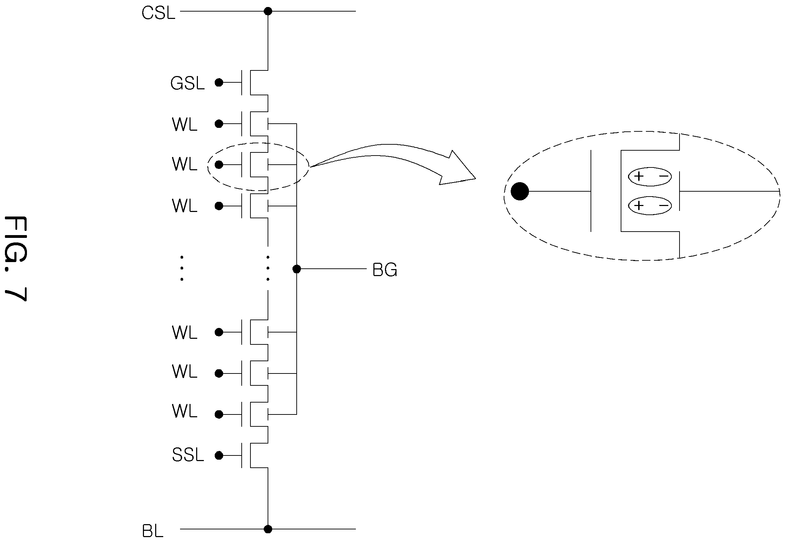

FIG. 7 is a simplified circuit diagram illustrating a memory cell array of a semiconductor device according to some example embodiments.

Referring to FIGS. 6A and 6B, an upper surface of a back gate electrode 150A may be located on a level, lower than a lower surface of an uppermost gate electrode (e.g., 130G) among gate electrodes 130, and a lower surface of the back gate electrode 150Amay be located on a level, higher than an upper surface of a lowermost gate electrode (e.g., 130S) among the gate electrodes 130. For example, the back gate electrode 150A may not horizontally overlap a channel layer 142 and/or a ferroelectric material layer 143 on the same level as the uppermost gate electrode (e.g., 130G) and/or the lowermost gate electrode (e.g., 130S). Referring to FIG. 7, a back gate line BG may apply an electrical signal to memory cells to which word lines WL are connected, and may not apply an electrical signal to a ground select transistor to which a ground select line GSL is connected, and a string selection transistor to which a string select line SSL is connected.

In a semiconductor device 100B1 of FIG. 6A, a back gate electrode 150A may be vertically recessed, and accordingly, a vertical height of a contact plug 173d may increase. In a vertical hole H, a first insulating layer 145 covering a recessed lower surface of the back gate electrode 150A and a lower region of an inner surface of a ferroelectric material layer 143, and a second insulating layer 181A covering a recessed upper surface of the back gate electrode 150A and an upper region of the inner surface of the ferroelectric material layer 143 may be arranged.

A semiconductor device 100B2 of FIG. 6B may be similar to the semiconductor device 100B1 of FIG. 6A, but a ferroelectric material layer 143A may also be vertically recessed, together with a back gate electrode 150A. An upper surface of the ferroelectric material layer 143A may be located on a level, lower than an upper surface of a channel layer 142, and may be located on a level, lower than a lower surface of an uppermost gate electrode (e.g., 130G). A lower surface of the ferroelectric material layer 143A may be located on a level, higher than a lower surface of the channel layer 142, and may be located on a level, higher than an upper surface of a lowermost gate electrode (e.g., 130S).

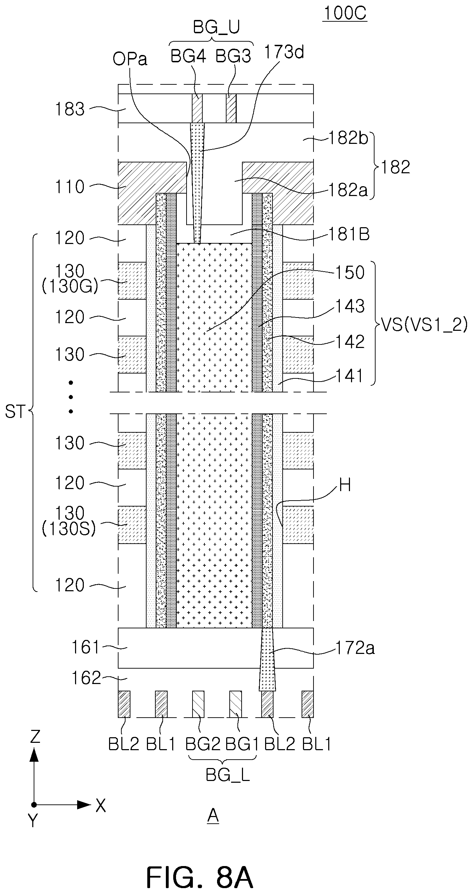

FIGS. 8A to 10 are partially enlarged views of semiconductor devices according to some example embodiments. FIGS. 8A to 10 illustrate regions corresponding to FIG. 4.

Referring to FIG. 8A, in a semiconductor device 100C, a width of an opening OPa passing through a source structure 110 may be narrower than a width of a back gate electrode 150. An inner wall of the opening OPa may be disposed in a first capping insulating layer 181B, and may be spaced apart from a ferroelectric material layer 143.

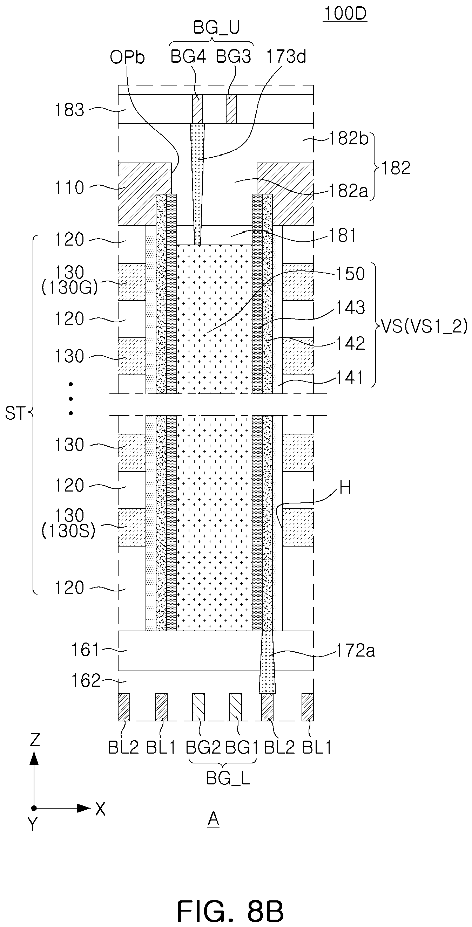

Referring to FIG. 8B, in a semiconductor device 100D, a width of an opening OPb passing through a source structure 110 may be wider than a width of a back gate electrode 150. At least a portion of an upper surface of a ferroelectric material layer 143 may be exposed through the opening OPb.

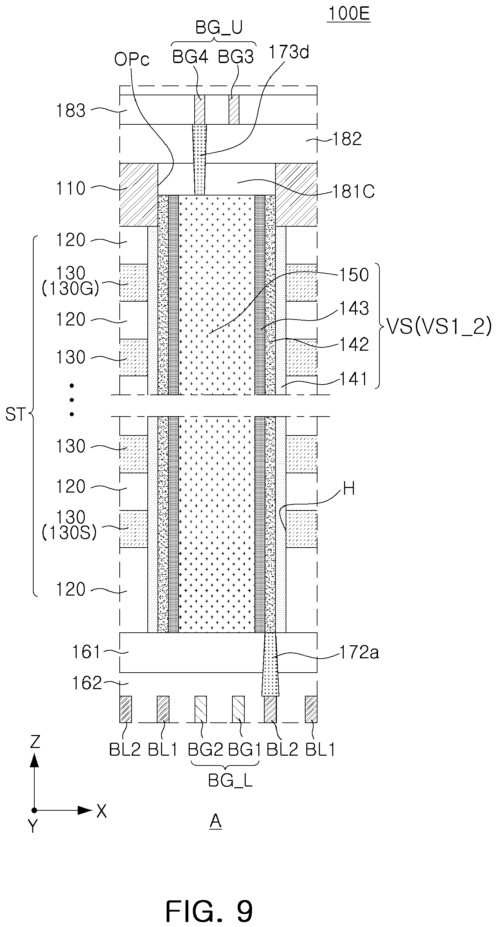

Referring to FIG. 9, in a semiconductor device 100E, a width of an opening OPc passing through a source structure 110 may be wider than a width of a back gate electrode 150, and at least a portion of an upper surface of a ferroelectric material layer 143 and at least a portion of an upper surface of a channel layer 142 may be exposed through the opening OPc. An upper surface of the back gate electrode 150 may be disposed on a level, higher than a lower surface of the source structure 110. The channel layer 142 may be in contact with the source structure 110 through an outer side surface.

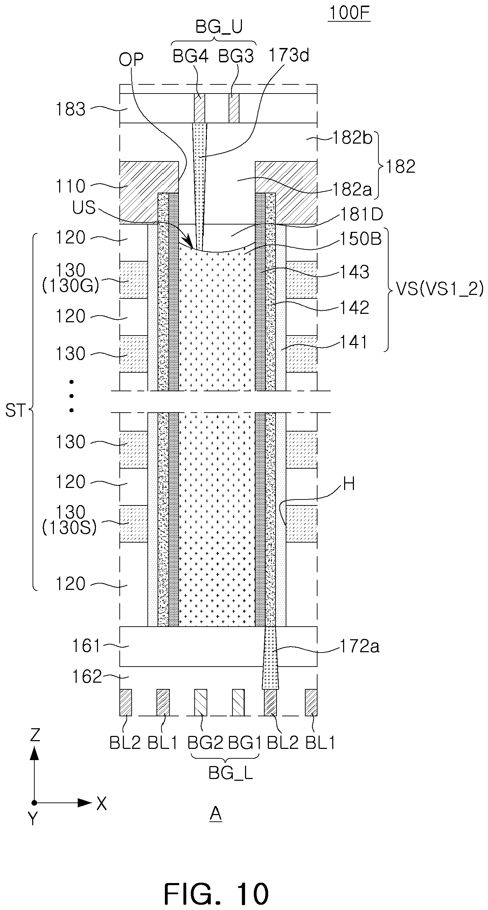

Referring to FIG. 10, in a semiconductor device 100F, an upper surface US of a back gate electrode 150B may have a concave shape in a downward direction, and a first capping insulating layer 181D may have a convex lower surface corresponding to the upper surface US. According to some example embodiments, a shape of the upper surface of the back gate electrode 150B may be changed.

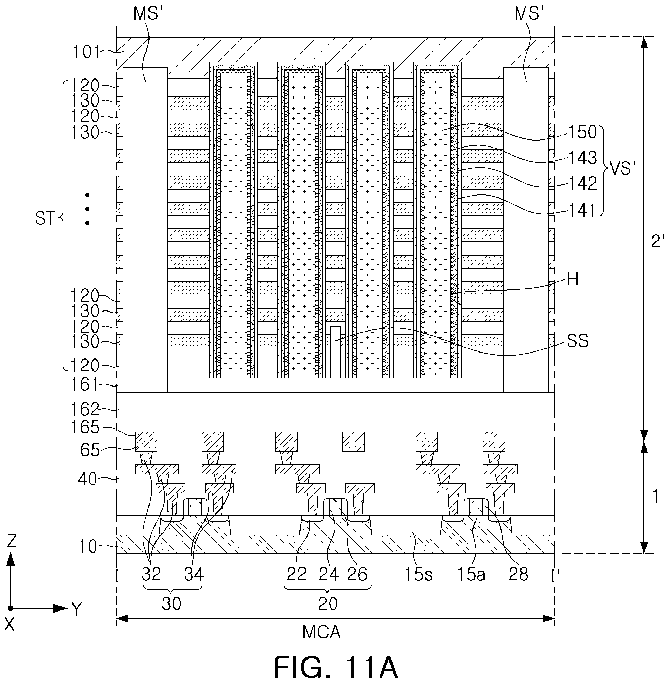

FIGS. 11A to 15B are schematic cross-sectional views illustrating a method of manufacturing a semiconductor device according to some example embodiments.

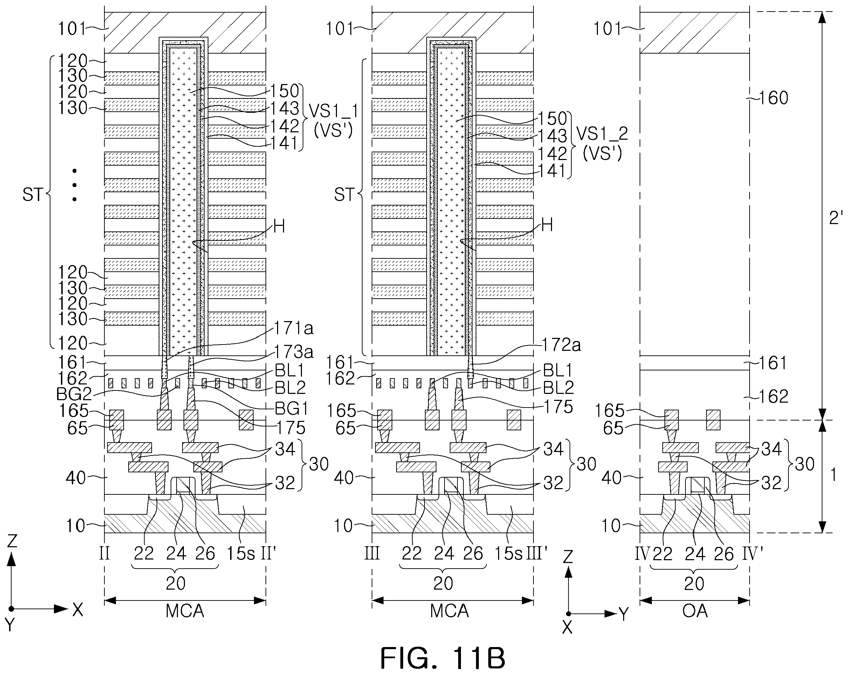

Referring to FIGS. 11A and 11B, a first structure 1 and a second structure 2' may be bonded to each other.

The first structure 1 and the second structure 2' may be connected to each other by pressing and bonding a lower bonding pad 65 and an upper bonding pad 165. A lower bonding insulating layer 40 and an upper bonding insulating layer 162 may also be pressed and bonded to each other. After forming the first structure 1 and the second structure 2', respectively, the second structure 2' may be turned over, and the second structure 2' may be bonded to the first structure 1 such that the upper bonding pad 165 faces the first structure 1. The first structure 1 and the second structure 2' may be directly bonded without an adhesive such as a separate adhesive layer intervening therebetween.

Formation of the first structure 1 may include forming circuit elements 20 forming a peripheral circuit region on a substrate 10, forming a lower interconnection structure 30, forming a lower insulating layer 40, and forming lower bonding pads 65.

Device isolation layers 15s may be formed in the substrate 10, and a circuit gate dielectric layer 24, a circuit gate electrode 26, and/or a spacer layer 28 may be sequentially formed on the substrate 10. The device isolation layers 15s may be formed by, for example, a shallow trench isolation (STI) process. The spacer layer 28 may be formed on both sidewalls of the circuit gate dielectric layer 24 and/or both sidewalls of the circuit gate electrode 26. Source/drain regions 22 may be formed in an active region 15a of the substrate 10 on both sides of the circuit gate electrode 26.

A lower contact 32 of the lower interconnection structure 30 may be formed by forming a portion of the lower insulating layer 40, removing the portion by etching the same, and then filling the removed portion with a conductive material. A lower interconnection 34 of the lower interconnection structure 30 may be formed by, for example, depositing a conductive material and then patterning the conductive material. The lower interconnection structure 30 may be formed by, for example, a deposition process and/or a plating process.

The lower bonding pads 65 may be formed by forming a portion of the lower insulating layer 40, removing the portion by etching the same, and then filling the removed portion with a conductive material, or may be formed by depositing a conductive material and then patterning the conductive material. A planarization process may be performed until upper surfaces of the lower bonding pads 65 are exposed.

The lower insulating layer 40 may be formed as a plurality of insulating layers. The lower insulating layer 40 may be a portion in each, or one or more, of forming the lower interconnection structure 30 and the lower bonding pads 65. Thereby, the first structure 1 may be formed.

Formation of the second structure 2' may include forming a preliminary stack structure on a base substrate 101, forming vertical structures VS' passing through the preliminary stack structure, and forming separation openings to remove sacrificial layers, forming the gate electrodes 130, in a region from which the sacrificial layers are removed, to form a stack structure ST, forming separation patterns MS, and forming lower capping insulating layers 161 and 162 and a first upper interconnection structure. In a portion of manufacturing a semiconductor device, the second structure 2' may be in a state in which the base substrate 101 is disposed on the stack structure ST, unlike FIGS. 3A and 3B.

Interlayer insulating layers 120 and the sacrificial layers may be alternately stacked on the base substrate 101. The base substrate 101 may include a semiconductor material, for example, a group IV semiconductor, a group III-V compound semiconductor, and/or a group II-VI compound semiconductor. The base substrate 101 may be, for example, a single crystal silicon substrate. The base substrate 101 may be provided as a bulk wafer or an epitaxial layer.

The sacrificial layers may be layers replaced with the gate electrodes 130 (refer to FIGS. 3A and 3B) by a subsequent process. The sacrificial layers may be formed of a material, different from that of the interlayer insulating layers 120. After stacking the sacrificial layers, a photolithography process and an etching process may be repeatedly performed to form a stepped structure in the sacrificial layers.

The vertical structures VS' may be formed by forming a vertical hole H passing through the preliminary stack structure and then filling an internal space of the vertical hole H with a plurality of layers. A gate insulating layer 141, a channel layer 142, a ferroelectric material layer 143, and/or a back gate electrode 150 may be sequentially formed in the vertical hole H. The vertical hole H may recess a portion of the base substrate 101. Before forming the vertical structures VS', a string separation pattern SS passing through a portion of the sacrificial layers may be formed.

Separation openings passing through the preliminary stack structure in the Z-direction and extending in the X-direction in a trench shape may be formed. The separation openings may recess a portion of the base substrate 101. Before forming the separation openings, a first lower capping insulating layer 161 covering the vertical structures VS' may be formed.

The sacrificial layers exposed through the separation openings may be selectively removed from side surfaces thereof with respect to the interlayer insulating layers 120. Therefore, horizontal openings may be formed between the interlayer insulating layers 120. In this operation, an insulating structure of the interlayer insulating layers 120 may be stably supported by the vertical structures VS'.

The gate electrodes 130 may be formed by filling the horizontal openings with a conductive material, and the separation patterns MS may be formed by filling the separation openings with an insulating material. Therefore, the stack structure ST may be formed.

Formation of the first upper interconnection structure may include forming lower contact plugs 171a, 171b, 172a, 172b, 173a, and/or 173b, bit lines BL, lower back gate interconnections BG_L, and/or upper bonding pads 165, respectively. In this operation, lower capping insulating layers 160, 161, and/or 162 may be formed.

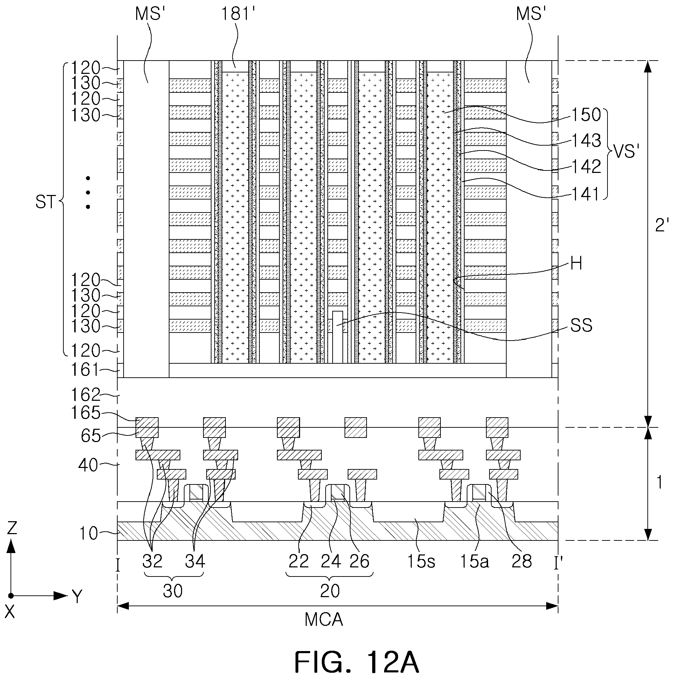

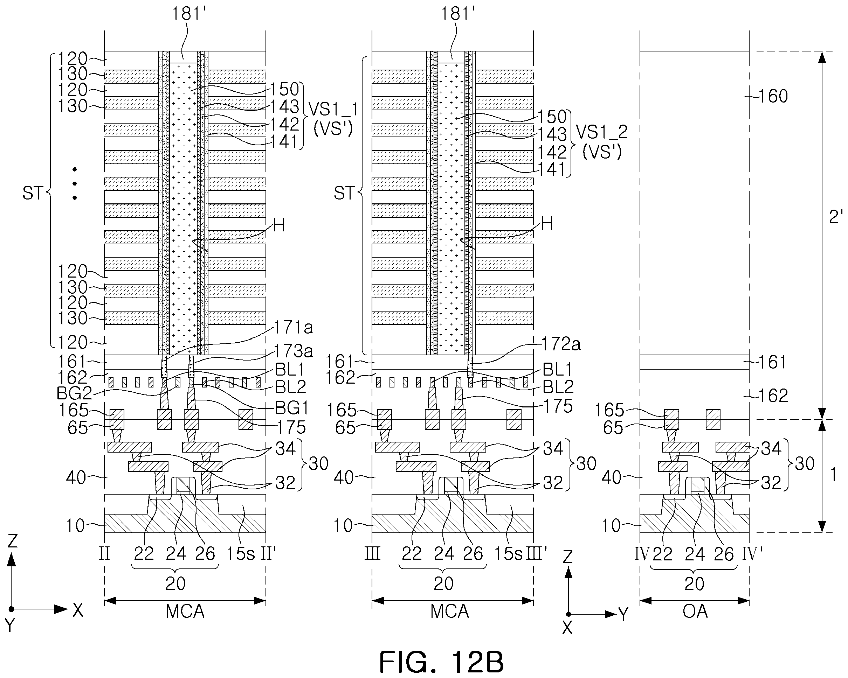

Referring to FIGS. 12A and 12B, a polishing process may be performed on the second structure 2' to remove the base substrate 101, and after recessing the back gate electrode 150, a first upper capping insulating layer 181' may be formed.

The base substrate 101 may be removed in, for example, a polishing process such as a grinding process, and/or a chemical-mechanical polishing process. The base substrate 101 may be removed from a rear surface thereof to expose upper surfaces of the vertical structures VS' and/or upper surfaces of the separation patterns MS'. As a portion of the vertical structures VS' is removed, upper surfaces of the back gate electrodes 150 may be exposed.

The exposed back gate electrodes 150 may be partially recessed from the upper surface thereof by an etching process. By the etching process, the upper surfaces of the back gate electrodes 150 may be located onto a level, lower than an upper surface of the channel layer 142. The first upper capping insulating layer 181' may be formed to cover an upper surface of the recessed back gate electrode 150. In the process of recessing the back gate electrodes 150, some example embodiments of the present inventive concepts may be manufactured.

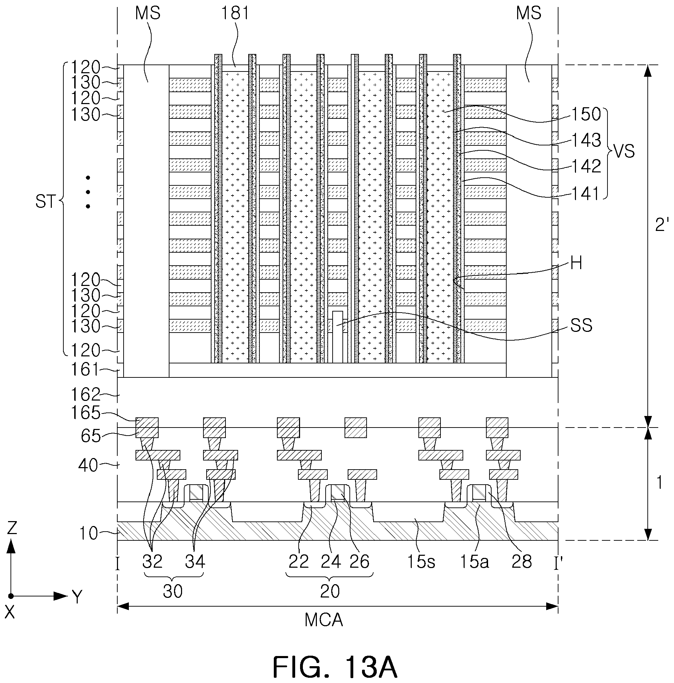

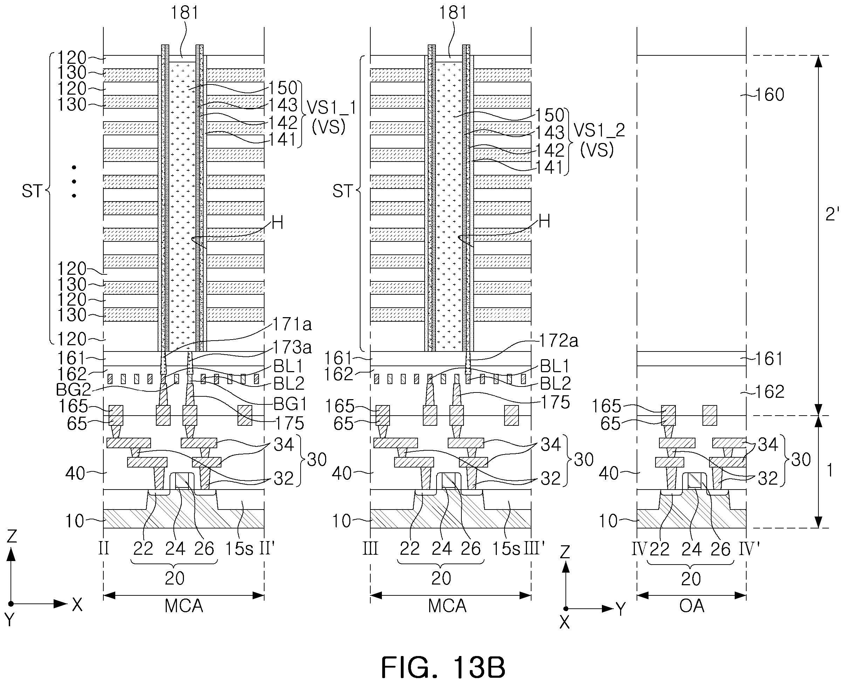

Referring to FIGS. 13A and 13B, a portion of the gate insulating layer 141 and a portion of an uppermost interlayer insulating layer 120 may be etched to expose an outer surface of the channel layer 142. In this operation, the first upper capping insulating layer 181' may be partially etched to form a first upper capping insulating layer 181 having a predetermined (or alternately given) reduced thickness, and the separation patterns MS may also be partially etched to form separation patterns MS.

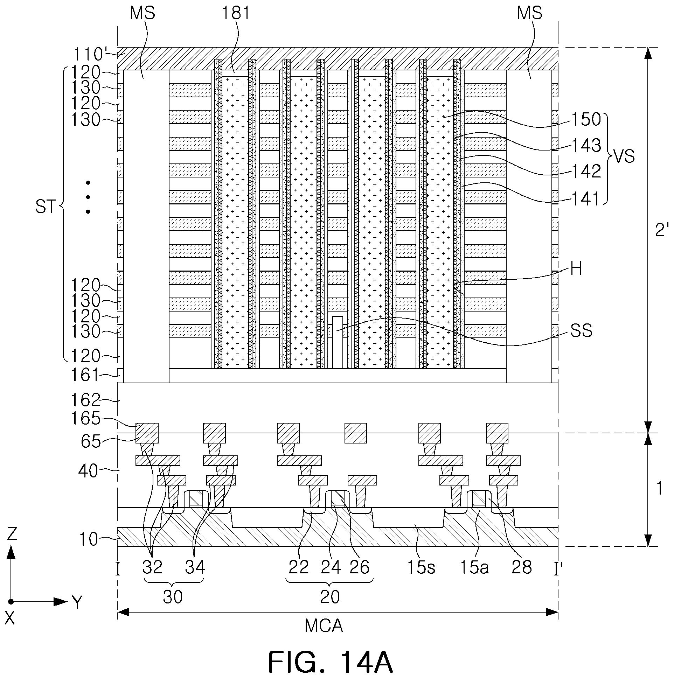

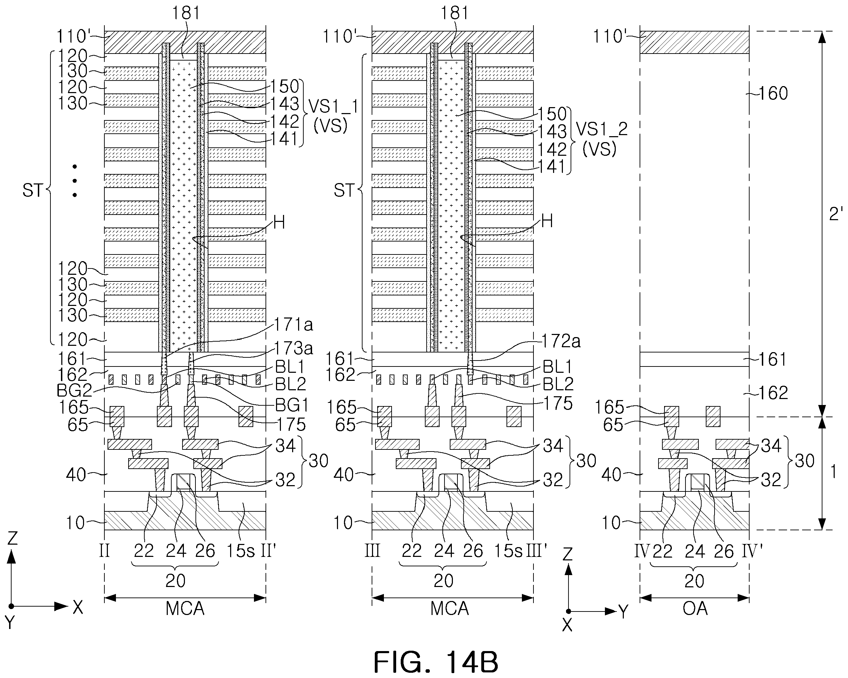

Referring to FIGS. 14A and 14B, a source structure 110' may be formed on the stack structure ST.

The source structure 110' may be formed to contact outer side and upper surfaces of the channel layer 142. The source structure 110' may be formed to contact inner side and/or upper surfaces of the ferroelectric material layer 143 and/or upper surfaces of the separation patterns MS.

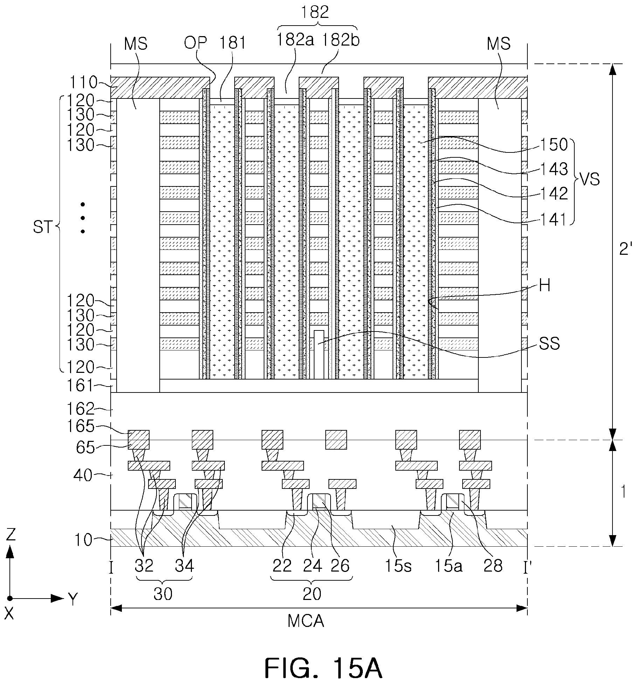

Referring to FIGS. 15A and 15B, the source structure 110' may be patterned to form openings OP, a second upper capping insulating layer 182 may be formed on a source structure 110', and upper contact plugs 173c and/or 173d passing through the second upper capping insulating layer 182 and a through-contact plug 200 passing through the insulating structures 160, 161, 162, and/or 182 may be formed.

A photolithography process and/or an etching process may be performed on the source structure 110', to form the openings OP passing through the source structure 110' and exposing at least a portion of the upper surface of the first upper capping insulating layer 181. The second upper capping insulating layer 182 may be formed to fill the openings OP and cover an upper surface of the source structure 110'. The upper contact plugs 173c and/or 173d may pass through the first upper capping insulating layer 181 and/or the second upper capping insulating layer 182, to be connected to the back gate electrodes 150. The through-contact plug 200 may be formed to land on the upper bonding pad 165. Thereafter, upper back gate interconnections BG_U may be formed on the upper contact plugs 173c and/or 173d to manufacture the semiconductor device 100 of FIGS. 3A and 3B. In forming the opening OP, some example embodiments of the present inventive concepts may be manufactured.

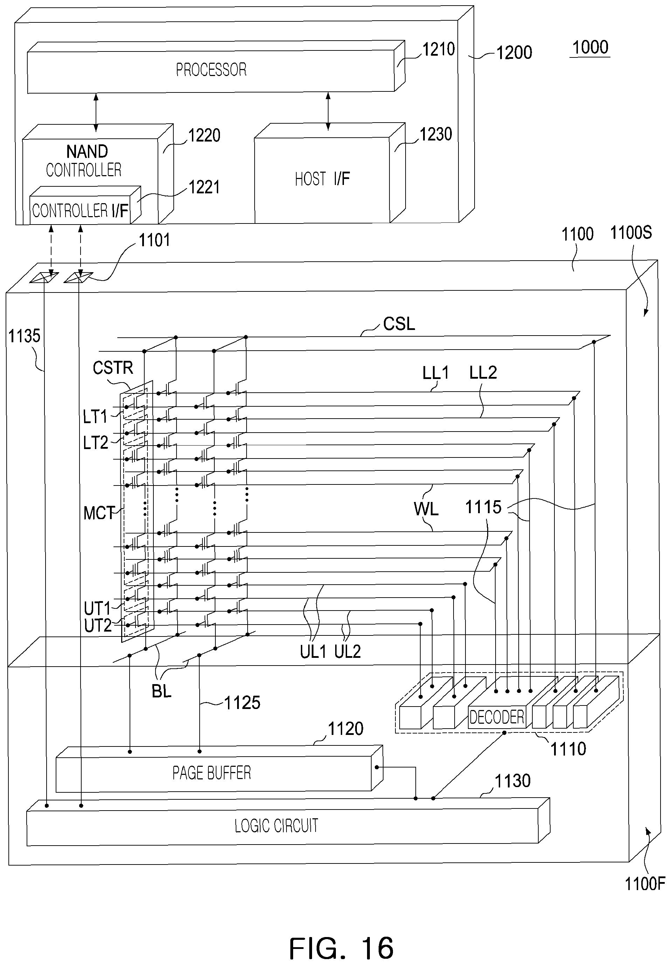

FIG. 16 is a view schematically illustrating a data storage system including a semiconductor device according to some example embodiments.

Referring to FIG. 16, a data storage system 1000 may include a semiconductor device 1100, and/or a controller 1200 electrically connected to the semiconductor device 1100. The data storage system 1000 may be a storage device including the semiconductor device 1100 as a single semiconductor device or a plurality of semiconductor devices, or an electronic device including the storage device. For example, the data storage system 1000 may be a solid state drive device (SSD), a universal serial bus (USB), a computing system, a medical device, and/or a communication device, including the semiconductor device 1100 as a single semiconductor device or a plurality of semiconductor devices.

The semiconductor device 1100 may be a non-volatile memory device, for example, a NAND flash memory device according to any of the example embodiments described above with reference to FIGS. 1 to 10. The semiconductor device 1100 may include a first semiconductor structure 1100F, and/or a second semiconductor structure 1100S on the first semiconductor structure 1100F. In some example embodiments, the first semiconductor structure 1100F may be disposed next to the second semiconductor structure 1100S. The first semiconductor structure 1100F may be a peripheral circuit structure including a decoder circuit 1110, a page buffer 1120, and/or a logic circuit 1130. The second semiconductor structure 1100S may be a memory cell structure including a bit line BL, a common source line CSL, word lines WL, first and/or second upper gate lines UL1 and UL2, first and/or second lower gate lines LL1 and/or LL2, and memory cell strings CSTR between the bit line BL and the common source line CSL.

In the second semiconductor structure 1100S, each, or one or more, of the memory cell strings CSTR may include lower transistors LT1 and/or LT2 adjacent to the common source line CSL, upper transistors UT1 and/or UT2 adjacent to the bit line BL, and/or a plurality of memory cell transistors MCT disposed between each, or one or more, of the lower transistors LT1 and/or LT2 and each, or one or more, of the upper transistors UT1 and/or UT2. The number of lower transistors LT1 and/or LT2 and the number of upper transistors UT1 and/or UT2 may be variously changed according to some example embodiments.

In some example embodiments, each, or one or more, of the upper transistors UT1 and/or UT2 may include a string select transistor, and each, or one or more, of the lower transistors LT1 and/or LT2 may include a ground select transistor. The lower gate lines LL1 and/or LL2 may be gate electrodes of the lower transistors LT1 and/or LT2, respectively. The word lines WL may be gate electrodes of the memory cell transistors MCT, and the upper gate lines UL1 and/or UL2 may be gate electrodes of the upper transistors UT1 and/or UT2, respectively.

In some example embodiments, the lower transistors LT1 and/or LT2 may include a lower erase control transistor LT1 and a ground select transistor LT2, connected in series. The upper transistors UT1 and/or UT2 may include a string select transistor UT1 and an upper erase control transistor UT2, connected in series. At least one of the lower erase control transistor LT1 and/or the upper erase control transistor UT2 may be used for an erase operation of erasing data stored in the memory cell transistors MCT using a gate-induced-drain-leakage (GIDL) phenomenon.

The common source line CSL, the first and/or second lower gate lines LL1 and LL2, the word lines WL, and/or the first and/or second upper gate lines UL1 and UL2 may be electrically connected to the decoder circuit 1110 through first connection interconnection structures 1115 extending from the first semiconductor structure 1100F into the second semiconductor structure 1100S. The bit lines BL may be electrically connected to the page buffer 1120 through second connection interconnection structures 1125 extending from the first semiconductor structure 1100F into the second semiconductor structure 1100S.

In the first semiconductor structure 1100F, the decoder circuit 1110 and/or the page buffer 1120 may perform a control operation on at least one selected memory cell transistor among the plurality of memory cell transistors MCT. The decoder circuit 1110 and/or the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through input/output connection interconnection structures 1135 extending from the first semiconductor structure 1100F into the second semiconductor structure 1100S.

The controller 1200 may include a processor 1210, a NAND controller 1220, and/or a host interface 1230. According to some example embodiments, the data storage system 1000 may include a plurality of semiconductor devices 1100, and in this case, the controller 1200 may control the plurality of semiconductor devices 1100.

The processor 1210 may control an overall operation of the data storage system 1000 including the controller 1200. The processor 1210 may operate according to a predetermined (or alternately given) firmware, and may access to the semiconductor device 1100 by controlling the NAND controller 1220. The NAND controller 1220 may include a controller interface 1221 processing communications with the semiconductor device 1100. A control command for controlling the semiconductor device 1100, data to be written to the memory cell transistors MCT of the semiconductor device 1100, data to be read from the memory cell transistors MCT of the semiconductor device 1100, or the like may be transmitted through the controller interface 1221. The host interface 1230 may provide a communication function between the data storage system 1000 and an external host. When a control command is received from the external host through the host interface 1230, the processor 1210 may control the semiconductor device 1100 in response to the control command.

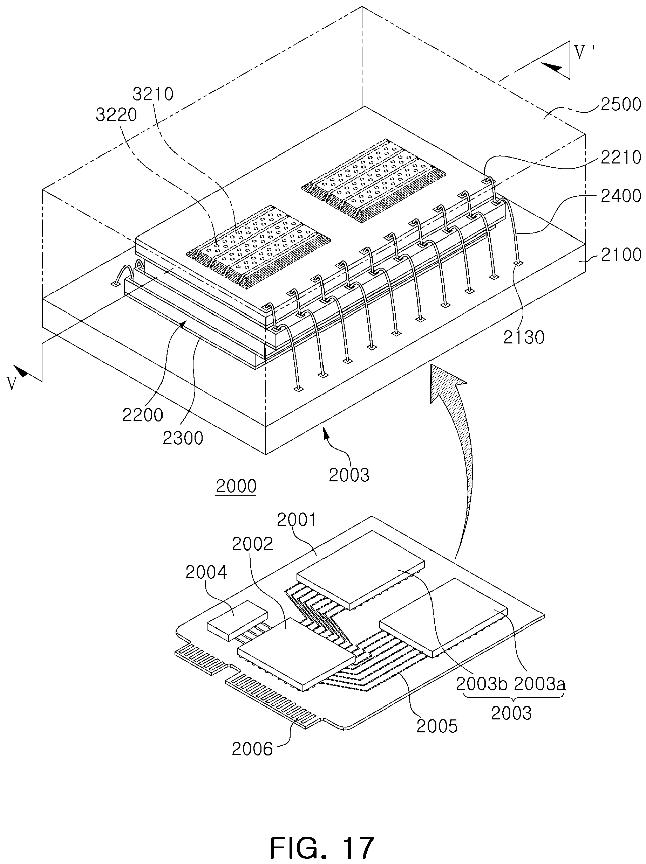

FIG. 17 is a perspective view schematically illustrating a data storage system including a semiconductor device according to some example embodiments.

Referring to FIG. 17, a data storage system 2000 according to some example embodiments of the present inventive concepts may include a main substrate 2001, a controller 2002 mounted on the main substrate 2001, at least one semiconductor package 2003, and/or a DRAM 2004. The semiconductor package 2003 and/or the DRAM 2004 may be connected to the controller 2002 by wiring patterns 2005 formed on the main substrate 2001.

The main substrate 2001 may include a connector 2006 including a plurality of pins, which may be coupled to an external host. The number and an arrangement of the plurality of pins in the connector 2006 may vary according to a communication interface between the data storage system 2000 and the external host. In some example embodiments, the data storage system 2000 may be communicated with the external host according to any one interface of a universal serial bus (USB), peripheral component interconnect express (PCI-Express), serial advanced technology attachment (SATA), M-Phy for universal flash storage (UFS), or the like. In some example embodiments, the data storage system 2000 may be operated by power supplied from the external host through the connector 2006. The data storage system 2000 may further include a power management integrated circuit (PMIC) distributing power, supplied from the external host, to the controller 2002 and/or the semiconductor package 2003.

The controller 2002 may write data to the semiconductor package 2003 and/or read data from the semiconductor package 2003, and may improve an operation speed of the data storage system 2000.

The DRAM 2004 may be a buffer memory reducing a difference in speed between the semiconductor package 2003, which may be a data storage space, and the external host. The DRAM 2004 included in the data storage system 2000 may also operate as a type of cache memory, and may provide a space temporarily storing data in a control operation on the semiconductor package 2003. When the DRAM 2004 is included in the data storage system 2000, the controller 2002 may further include a DRAM controller controlling the DRAM 2004 in addition to a NAND controller controlling the semiconductor package 2003.

The semiconductor package 2003 may include first and/or second semiconductor packages 2003a and 2003b, spaced apart from each other. Each, or one or more, of the first and/or second semiconductor packages 2003a and 2003b may be a semiconductor package including a plurality of semiconductor chips 2200. Each, or one or more, of the first and/or second semiconductor packages 2003a and 2003b may include a package substrate 2100, semiconductor chips 2200 on the package substrate 2100, adhesive layers 2300 disposed on a lower surface of each, or one or more, of the semiconductor chips 2200, a connection structure 2400 electrically connecting each, or one or more, of the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each, or one or more, of the semiconductor chips 2200 may include an input/output pad 2210. The input/output pad 2210 may correspond to the input/output pad 1101 of FIG. 16, and may be a region including the pad layer 230 of FIG. 2A. Each, or one or more, of the semiconductor chips 2200 may include gate stack structures 3210 and/or channel structures 3220. Each, or one or more, of the semiconductor chips 2200 may include the semiconductor device described above with reference to FIGS. 1 to 10.

In some example embodiments, the connection structure 2400 may be a bonding wire electrically connecting the input/output pad 2210 and the upper package pads 2130. Therefore, in each, or one or more, of the first and/or second semiconductor packages 2003a and 2003b, the semiconductor chips 2200 may be electrically connected to each other by a bonding wire process, and may be electrically connected to the package upper pads 2130 of the package substrate 2100. According to some example embodiments, in each, or one or more, of the first and second semiconductor packages 2003a and 2003b, the semiconductor chips 2200 may be electrically connected to each other by a connection structure including a through silicon via (TSV), instead of a connection structure 2400 by a bonding wire process.

In some example embodiments, the controller 2002 and the semiconductor chips 2200 may be included in one (1) package. In some example embodiments, the controller 2002 and/or the semiconductor chips 2200 may be mounted on a separate interposer substrate, different from the main substrate 2001, and the controller 2002 and the semiconductor chips 2200 may be connected to each other by a wiring formed on the interposer substrate.

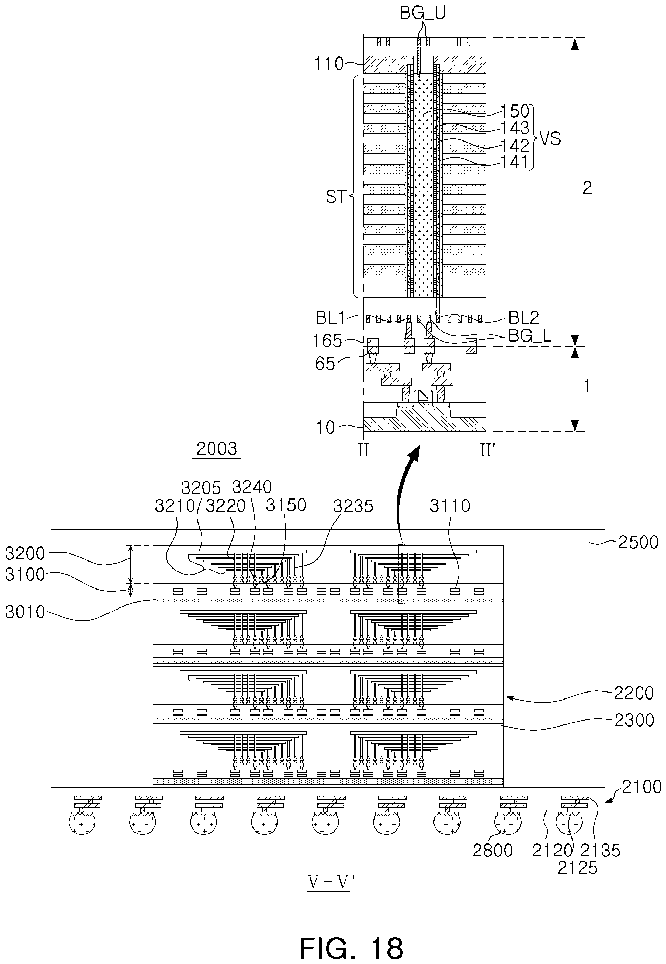

FIG. 18 is a cross-sectional view schematically illustrating a semiconductor package according to some example embodiments. FIG. 18 illustrates an example embodiment of the semiconductor package 2003 of FIG. 17, and conceptually illustrates a region of the semiconductor package 2003 of FIG. 17, taken along line V-V'.

Referring to FIG. 18, in the semiconductor package 2003, the package substrate 2100 may be a printed circuit board. The package substrate 2100 may include a package substrate body portion 2120, package upper pads 2130 (refer to FIG. 17) disposed on an upper surface of the package substrate body portion 2120, lower pads 2125 disposed on a lower surface of the package substrate body portion 2120 or exposed from the lower surface, and/or internal interconnections 2135 electrically connecting the upper pads 2130 and the lower pads 2125 in the package substrate body portion 2120. The upper pads 2130 may be electrically connected to the connection structures 2400. The lower pads 2125 may be connected to the wiring patterns 2005 of the main substrate 2001 of the data storage system 2000, as illustrated in FIG. 17, through-conductive connection portions 2800.

Each, or one or more, of the semiconductor chips 2200 may include a semiconductor substrate 3010, and/or a first semiconductor structure 3100 and a second semiconductor structure 3200, sequentially stacked on the semiconductor substrate 3010. The first semiconductor structure 3100 may include a peripheral circuit region including peripheral interconnections 3110. The second semiconductor structure 3200 may include a common source line 3205, a gate stack structure 3210 on the common source line 3205, channel structures 3220 and separation regions, passing through the gate stack structure 3210, bit lines 3240 electrically connected to the channel structures 3220, and/or contact plugs 3235 electrically connected to the word lines WL (refer to FIG. 17) of the gate stack structure 3210. As described above with reference to FIGS. 1 to 10, each, or one or more, of the semiconductor chips 2200 may include a substrate 10, a source structure 110, a stack structure ST, a vertical structure VS, bit lines (e.g., BL1 and/or BL2), lower back gate interconnections BG_L, upper back gate interconnections BG_U, and/or bonding pads 65 and 165.

Each, or one or more, of the semiconductor chips 2200 may include a through-interconnection 3150 electrically connected to the peripheral interconnections 3110 of the first semiconductor structure 3100 and extending into the second semiconductor structure 3200. The through-interconnection 3150 may be disposed outside the gate stack structure 3210, and may further be disposed to pass through the gate stack structure 3210. Each, or one or more, of the semiconductor chips 2200 may further include an input/output pad 2210 (refer to FIG. 17) electrically connected to the peripheral interconnections 3110 of the first semiconductor structure 3100, and the input/output pad 2210 may be a region including the pad layer 230.

According to some example embodiments of the present inventive concepts, a semiconductor device having improved electrical characteristics and reliability and a data storage system including the same may be provided by disposing upper back gate interconnections and lower back gate interconnections above and below a vertical structure including a channel layer, a semiconductor device having improved electrical characteristics and reliability and a data storage system including the same may be provided.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

Various advantages and effects of the present inventive concepts are not limited to the above, and will be more easily understood in the process of describing some example embodiments of the present inventive concepts.

While some example embodiments have been illustrated and described above, it will be apparent to those skilled in the art that modifications and variations could be made without departing from the scope of the present inventive concepts as defined by the appended claims.

## Claims

1. A semiconductor device comprising:
a first structure including:
a sub strate,
circuit elements on the substrate,
a lower interconnection structure electrically connected to the circuit elements, and
lower bonding pads electrically connected to the lower interconnection structure; and
a second structure on the first structure, the second structure including:
a source structure,
gate electrodes stacked below the source structure and extending in a first direction,
first and second vertical structures passing through the gate electrodes,
a first upper interconnection structure below the gate electrodes and the first and second vertical structures,
a second upper interconnection structure on the source structure, and
upper bonding pads electrically connected to the first and second upper interconnection structures and bonded to the lower bonding pads,
wherein each of the first and second vertical structures includes:
a back gate electrode,
a ferroelectric material layer on a side surface of the back gate electrode,
a channel layer on a side surface of the ferroelectric material layer and electrically connected to the source structure, and
a gate insulating layer between the channel layer and the gate electrodes,
wherein the first upper interconnection structure includes:
bit lines extending in a second direction intersecting the first direction,
a first contact plug electrically connected to a lower surface of a first back gate electrode of the first vertical structure, and
a first back gate interconnection extending between the bit lines in the second direction and electrically connected to the first contact plug, and
wherein the second upper interconnection structure includes:
a second contact plug electrically connected to an upper surface of a second back gate electrode of the second vertical structure, and
a second back gate interconnection extending in the second direction and electrically connected to the second contact plug.

2. The semiconductor device of claim 1, wherein the upper surface of the second back gate electrode is on a level lower than a level of a lower surface of the source structure.

3. The semiconductor device of claim 1 or 2, wherein:
the source structure includes an opening vertically overlapping at least a portion of the second back gate electrode,
the second structure further includes an insulating layer on the source structure,
the insulating layer includes:
a first portion extending into the opening of the source structure, and
a second portion covering an upper surface of the source structure, and
the second contact plug passes through the first portion of the insulating layer in the opening.

4. The semiconductor device of any preceding claim, wherein:
the first back gate interconnection is on a same level as the bit lines, and
the second back gate interconnection is on a higher level than an upper surface of the source structure.

5. The semiconductor device of any preceding claim, wherein the first vertical structure and the second vertical structure are adjacent to each other in the second direction.

6. The semiconductor device of claim 5, wherein
the bit lines include a first bit line and a second bit line in parallel with each other, and
the first upper interconnection structure further includes:
a first bit line contact plug between a first channel layer of the first vertical structure and the first bit line, and
a second bit line contact plug between a second channel layer of the second vertical structure and the second bit line.

7. The semiconductor device of claim 6, further comprising:
third and fourth vertical structures passing through the gate electrodes,
wherein the second upper interconnection structure includes:
a third contact plug electrically connected to an upper surface of a third back gate electrode of the third vertical structure,
a fourth contact plug electrically connected to a lower surface of a fourth back gate electrode of the fourth vertical structure,
a third back gate interconnection extending in the second direction and electrically connected to the third contact plug, and
a fourth back gate interconnection extending in the second direction and electrically connected to the fourth contact plug.

8. The semiconductor device of claim 7, wherein
the fourth back gate interconnection is on a same level as the bit lines, and
the third back gate interconnection is on a higher level than an upper surface of the source structure.

9. The semiconductor device of claim 7 or 8, wherein
the first upper interconnection structure further comprises:
a third bit line contact plug between a third channel layer of the third vertical structure and the first bit line; and
a fourth bit line contact plug between a fourth channel layer of the fourth vertical structure and the second bit line.

10. The semiconductor device of any preceding claim, wherein the ferroelectric material layer includes at least one of hafnium (Hf), zirconium (Zr), silicon (Si), yttrium (Y), aluminum (Al), gadolinium (Gd), strontium (Sr), lanthanum (La), titanium (Ti), or an oxide thereof.

11. The semiconductor device of any preceding claim, wherein the second structure further comprises a through-contact plug electrically connecting the second back gate interconnection and the circuit elements to each other and extending in a third direction, perpendicular to an upper surface of the substrate.

12. A semiconductor device comprising:
circuit elements on a substrate;
a lower interconnection structure electrically connected to the circuit elements;
lower bonding pads electrically connected to the lower interconnection structure;
upper bonding pads bonded to the lower bonding pads;
a first upper interconnection structure and a second upper interconnection structure electrically connected to the upper bonding pads;
gate electrodes between the first upper interconnection structure and the second upper interconnection structure, the gate electrodes stacked spaced apart from each other and extending in a first direction;
vertical structures passing through the gate electrodes; and
a source structure contacting upper ends of the vertical structures,
wherein each of the vertical structures includes:
a back gate electrode,
a ferroelectric material layer on a side surface of the back gate electrode,
a channel layer on a side surface of the ferroelectric material layer and electrically connected to the source structure, and
a gate insulating layer between the channel layer and the gate electrodes,
wherein the vertical structures include first to fourth vertical structures arranged in a line in a second direction, intersecting the first direction,
wherein the first upper interconnection structure includes:
first and second bit lines extending in the second direction and parallel to each other, and
first and second back gate interconnections extending in the second direction and parallel to each other between the first and second bit lines, and
wherein the second upper interconnection structure includes third and fourth back gate interconnections extending in the second direction on a higher level than the source structure and parallel to each other.

13. The semiconductor device of claim 12, wherein an upper surface of the back gate electrode is on a level lower than a level of a lower surface of the source structure.

14. The semiconductor device of claim 12 or 13, wherein an outer side surface and an upper surface of the channel layer are in contact with the source structure.

15. The semiconductor device of claim 12, 13 or 14, wherein the first upper interconnection structure further comprises:
a first contact plug electrically connected to a lower surface of a first back gate electrode of the first vertical structure; and
a second contact plug electrically connected to an upper surface of a third back gate electrode of the third vertical structure,
wherein the first contact plug is electrically connected to the first back gate interconnection, and
wherein the second contact plug is electrically connected to the third back gate interconnection.
